# EUROPEAN PATENT SPECIFICATION

(11) **EP 4 152 471 B1**
(45) Date of publication and mention of the grant of the patent: **06.08.2025**
(21) Application number: 21803806.5
(22) Date of filing: 11.05.2021
(51) Int. Cl.: H01M 10/42, H01M 10/48, H02J 7/00, G01R 31/367, G01R 31/387, G01R 31/392

(54) **ANALYSIS DEVICE, ANALYSIS SYSTEM, AND ANALYSIS METHOD**
ANALYSEVORRICHTUNG, ANALYSESYSTEM UND ANALYSEVERFAHREN
DISPOSITIF, SYSTÈME ET PROCÉDÉ D'ANALYSE

(30) Priority: 15.05.2020 JP 2020086223
(43) Date of publication of application: 22.03.2023
(73) Proprietor: Yokogawa Electric Corporation, Musashino-shi, Tokyo 180-8750 (JP)
(72) Inventor: KAZUMI, Masahiro, Musashino-shi, Tokyo 180-8750 (JP); MATSUSHITA, Takeshi, Musashino-shi, Tokyo 180-8750 (JP)
(74) Representative: Winter, Brandl - Partnerschaft mbB
(86) International application number: PCT/JP2021/017815
(87) International publication number: WO 2021/230225

(56) References cited:
- WO-A1-2014/147973
- JP-A- 2016 053 564
- JP-A- 2018 119 839
- US-A1- 2019 198 938
- US-B1- 10 511 050

## Description

### BACKGROUND

### 1. TECHNICAL FIELD

The present invention relates to an analysis device, an analysis system, and an analysis method.

### 2. RELATED ART

Conventionally, there is known a system that analyzes characteristics such as a maximum capacity of a battery (also referred to as full charge capacity) (see, for example, Patent Document 1).
Patent Document 1: Japanese Patent No. 6123844

Document US 10 511 050 B1 describes a method for determining the health of a battery. The battery health is determined by estimating a battery anode capacity, battery cathode capacity, and cyclable lithium capacity. Determining electrode and lithium capacity includes determining anode and cathode open cell voltages (OCV) at the beginning of battery life, and estimating the full cell OCV from the individual (half-cell) OCV values. Once the beginning of battery life information is known, the state of charge (SOC) for a battery is measured during battery life. The SOC measurements may be captured at a plurality of different levels. The cathode capacity, anode capacity, and cycle mobile lithium capacity are then determined from the beginning of life OCV data and plurality of SOC data.

Document US 2019/198938 A1 describes a battery safety evaluation apparatus which includes an estimator, a calculator, and an evaluator. The estimator estimates an estimation value of an inner state parameter of a battery to be evaluated on the basis of data of its voltage and current measured in charging or discharging it. The calculator calculates an index regarding swelling risk of the battery on the basis of first reference data. The evaluator evaluates, on the basis of the index, a battery swelling risk of the battery to evaluate safety of the battery. The battery is a secondary battery. The first reference data is reference data considered to correspond to the battery from the reference data on the basis of estimation value. The reference data indicates at least one of relationships between a positive electrode capacity, a negative electrode capacity and an SOC deviation of a secondary battery.

For analyzing battery characteristics with high accuracy, it is necessary to mount a high-performance analysis system in each battery.

### GENERAL DISCLOSURE

An analysis device of the present invention is defined in claim 1.

The data acquisition unit may be configured to acquire the identification data in which module identification data for identifying the battery modules and cell identification data for identifying the battery cells are associated with each other. The data analysis unit may be configured to analyze the characteristics related to the charging capacity of the battery cell for each of the battery modules.

The analysis device may further include an analysis data recording unit configured to record the measurement data acquired by the data acquisition unit over time, in association with the identification data.

The data analysis unit may be configured to generate control data for controlling the battery cell based on the analysis result. The data transmission unit may be configured to transmit the transmission data including the control data.

The data analysis unit may be configured to calculate a remaining capacity of each of the battery cells in each of the battery modules based on the measurement data. The data analysis unit may be configured to generate the control data for discharging at least one of the battery cells in which the remaining capacity is not smallest to reduce a difference between the remaining capacity of the at least one of the battery cells and the remaining capacity of the battery cell in which the remaining capacity is smallest.

The data analysis unit may be configured to generate replacement time data indicating a time to replace the battery cell based on the analysis result. The data transmission unit may be configured to transmit the transmission data including the replacement time data.

The data analysis unit may be configured to generate failure data indicating a failure of the battery cell based on the analysis result. The data transmission unit may be configured to transmit the transmission data including the failure data.

The data analysis unit may be configured to analyze the characteristics related to the charging capacity of the battery cell based on derivation characteristics of capacitance-voltage characteristics during charging or discharging of the battery cell.

The data acquisition unit may be configured to acquire the analysis data including temperature data indicating a temperature of the battery cell at a time of measuring the capacitance-voltage characteristics. The data analysis unit may be configured to correct the analysis by the derivation characteristics based on the temperature of the battery cell.

The analysis device may further include a reference characteristics recording unit having recorded thereon reference characteristics of the derivation characteristics of each of the battery cells. The reference characteristics may include one or more reference feature points. The data analysis unit may be configured to analyze the battery cell based on a measurement feature point in the derivation characteristics of the battery cell and the one or more reference feature points in the reference characteristics.

The reference characteristics recording unit may be configured to record at least one of the reference characteristics at the charging of the battery cell or the reference characteristics at the discharging of the battery cell. The data analysis unit may be configured to select the reference characteristics to be compared with the derivation characteristics, based on which of data obtained during the charging or data obtained during the discharging the measurement data of the battery cell is.

The data analysis unit may be configured to calculate a deterioration rate of the battery cell based on a deterioration amount of the battery cell calculated from the derivation characteristics.

The data analysis unit may be configured to calculate a measurement interval for measuring data related to the charging and discharging of the battery cell, based on the deterioration rate of the battery cell. The data transmission unit may be configured to transmit the transmission data corresponding to the measurement interval.

The data analysis unit may be configured to calculate, based on a deviation amount of the charging capacities between two or more of the battery cells, the deviation amount being calculated from the derivation characteristics of the two or more of the battery cells, a deviation rate of the charging capacities between the two or more of the battery cells.

The data analysis unit may be configured to calculate the measurement interval for measuring the data related to the charging and discharging of the two or more of the battery cells based on the deviation rate of the two or more of the battery cells. The data transmission unit may be configured to transmit the transmission data corresponding to the measurement interval.

An analysis system of the present invention is defined in claim 16.

A battery module analysis method of the present invention is defined in claim 17.

The summary clause does not necessarily describe all necessary features of the embodiments of the present invention. The present invention may also be a sub-combination of the features described above.

### BRIEF DESCRIPTION OF THE DRAWINGS

Fig. 1 shows a configuration example of an analysis system 10 according to an embodiment of the present invention.
Fig. 2 illustrates a detailed configuration example of the analysis system 10.
Fig. 3 shows an example of analysis data.
Fig. 4 shows an example of transmission data.
Fig. 5 illustrates variations in remaining capacities of battery cells 204 included in a battery module 202.
Fig. 6 shows another configuration example of an analysis device 100.
Fig. 7 illustrates an example of measurement data included in analysis data.
Fig. 8 shows an example of reference characteristics recorded by a reference characteristics recording unit 110.
Fig. 9 illustrates a method of calculating a remaining capacity of the battery cell 204 from reference characteristics and derivation characteristics.
Fig. 10 illustrates processing of reducing variations of the remaining capacities of the plurality of battery cells 204 included in the battery module 202.
Fig. 11 shows an example of capacitance-voltage characteristics during discharging of the battery cell 204.
Fig. 12 shows an example of the reference characteristics during discharging of the battery cell 204.
Fig. 13 illustrates an overview of charging and discharging of the battery cell 204.
Fig. 14 illustrates another example of the processing for reducing variations of the remaining capacities of the plurality of battery cells 204 included in the battery module 202.
Fig. 15 illustrates an overview of the battery module 202.
Fig. 16 is a flowchart showing an operation example of the analysis device 100.
Fig. 17 is a flowchart showing operation examples of a battery management device 206, a measurement unit 208, and an analysis data transmission unit 200.
Fig. 18 shows another example of an analysis content in a data analysis unit 104.
Fig. 19 shows another example of the analysis content in the data analysis unit 104.
Fig. 20 shows a transition example of an effective capacity of the battery module 202.
Fig. 21 shows an example of a deterioration detection of the battery cell 204.
Fig. 22 shows another example of the analysis content in the data analysis unit 104.
Fig. 23 shows another example of the analysis content in the data analysis unit 104.
Fig. 24 shows an operation example of the data analysis unit 104.
Fig. 25 shows another configuration example of the battery module 202.
Fig. 26 shows an example of a computer 2200 in which a plurality of aspects of the present invention may be wholly or partly embodied.

### DESCRIPTION OF EXEMPLARY EMBODIMENTS

Hereinafter, the present invention will be described through embodiments of the invention, but the following embodiments do not limit the claimed invention. In addition, not all of the combinations of features described in the embodiments are essential to the solving means of the invention.

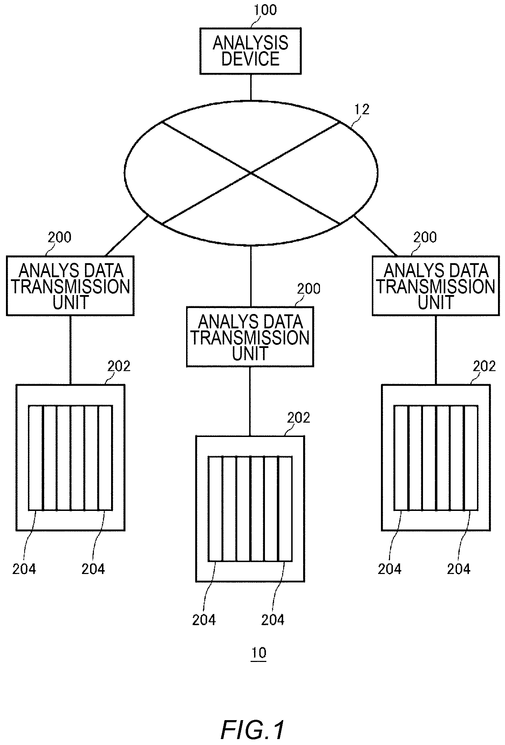

Fig. 1 shows a configuration example of an analysis system 10 according to an embodiment of the present invention. The analysis system 10 collects measurement data obtained by measuring characteristics of one or more battery modules 202 via a network 12, and analyzes a state of the battery modules 202. The analysis system 10 of the present example includes an analysis device 100 and one or more analysis data transmission units 200.

Each of the battery modules 202 includes one or more battery cells 204. The battery cell 204 has a configuration with which electrical power can be generated by the battery cell alone. For example, each of the battery cells 204 includes a negative electrode, a positive electrode, and a body portion that generates electrical power between both electrodes. The battery module 202 may include a plurality of battery cells 204 connected in series. Alternatively, the battery module 202 may include a plurality of battery cells 204 connected in parallel. A group of battery cells 204 electrically connected in series or parallel may be given as a single battery module 202. Alternatively, a group of battery cells 204 accommodated in a common housing may be given as a single battery module 202.

The analysis data transmission unit 200 transmits analysis data for analyzing characteristics of the battery module 202 to the analysis device 100 via the network 12. The analysis data transmission unit 200 may be provided for each battery module 202, or may be provided in common for the plurality of battery modules 202. The analysis data transmission unit 200 may be provided in a housing of the battery module 202. **In** another example, the analysis data transmission unit 200 may be provided apart from the battery module 202. **In** this case, it is preferable for the analysis data transmission unit 200 to be provided while being communicable with the battery module 202.

The analysis data includes measurement data obtained by measuring characteristics related to charging and discharging of the one or more battery cells 204 included in the battery module 202. The characteristics related to charging and discharging may be electrical characteristics of the battery cell 204 in at least one of timings including a start of charging, during charging, an end of charging, a start of discharging, during discharging, or an end of discharging of the battery cell 204. The electrical characteristics may include at least one of an interpolar voltage, an output current, a remaining capacity value, or an output resistance of the battery cell 204. Further, the electrical characteristics may include a temporal change of at least one of the interpolar voltage or the output current of the battery cell 204. Furthermore, the electrical characteristics may include a temporal change such as deterioration, of at least one of the remaining capacity value or the output resistance of the battery cell 204. Further, the interpolar voltage described above may be an interpolar voltage of the battery module 202 including the plurality of battery cells 204 connected in series or an interpolar voltage of a unit in which the plurality of battery modules 202 are combined.

The analysis data includes identification data associated with measurement data. The identification data includes at least one of module identification data for identifying the battery module 202 or cell identification data for identifying the battery cell 204. The module identification data may be serial numbers allocated to the plurality of battery modules 202. The cell identification data may be a serial number allocated to the one or more battery cells 204 included in the battery module 202.

The network 12 is, for example, the Internet or a local area network, though is not limited thereto. The network 12 may be a dedicated network for connecting the plurality of analysis data transmission units 200 and the analysis device 100, or may be a general-purpose network for also performing communication other than communication between the analysis data transmission unit 200 and the analysis device 100.

The analysis device 100 acquires analysis data of each of the battery modules 202 via the network 12. The analysis device 100 analyzes characteristics related to a charging capacity of the one or more battery cells 204 included in the battery module 202 based on the analysis data. In the present specification, when not mentioned in particular, a unit of a battery capacity is ampere-hour (Ah). The analysis device 100 may be a device that processes information using a single computer, or may be a device that performs decentralized information processing using a plurality of computers. The characteristics related to the charging capacity may include at least one of a full charge capacity of the battery cell 204, a remaining capacity of the battery cell 204, a measurement value of an internal resistance of the battery cell 204, a temporal change amount of deterioration or the like regarding these characteristics, or a variation amount of these characteristics among the battery cells 204 included in the battery module 202. Note that in the present specification, the full charge capacity or the remaining capacity may be referred to as the charging capacity (or capacity). That is, the charging capacity (or capacity) in the present specification conceptually includes both the full charge capacity and the remaining capacity.

The analysis device 100 may transmit an analysis result to outside. The analysis device 100 may transmit the analysis result to a device including the analysis data transmission unit 200, or may transmit the analysis result to a device different from the analysis data transmission unit 200.

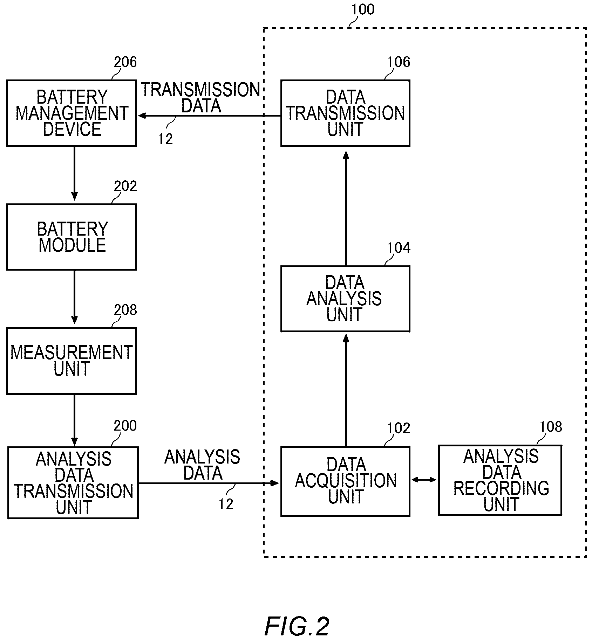

Fig. 2 illustrates a detailed configuration example of the analysis system 10. The analysis system 10 of the present example includes, in addition to the configuration shown in Fig. 1, a battery management device 206 and a measurement unit 208. The battery management device 206 and the measurement unit 208 may be provided with respect to each of the battery modules 202. Fig. 2 shows the battery management device 206, the measurement unit 208, and the analysis data transmission unit 200 accompanying one battery module 202. Note that each of the analysis data transmission unit 200, the battery management device 206, and the measurement unit 208 may be incorporated into the battery module 202, or may be attached separately to a single battery module 202.

The measurement unit 208 generates measurement data obtained by measuring electrical characteristics of the battery module 202. The measurement unit 208 may include at least one of an ammeter or a voltmeter. The analysis data transmission unit 200 transmits, to the analysis device 100, analysis data including the measurement data generated by the measurement unit 208 and identification data of the battery module 202 or the like.

The battery management device 206 receives transmission data from the analysis device 100. The battery management device 206 may control the battery module 202 based on the received transmission data. Further, the battery management device 206 may also provide information corresponding to the received transmission data to a user of the battery module 202. As an example, the battery management device 206 may charge and discharge each of the battery cells 204 based on the remaining capacity of each of the battery cells 204 indicated in the transmission data. **In** another example, the transmission data may include control data for controlling each of the battery cells 204 to charge and discharge. Further, the battery management device 206 may provide information related to the capacity of each of the battery cells 204 to the user.

The battery management device 206 may be included in the same device as the analysis data transmission unit 200. **In** this case, the analysis device 100 may transmit and receive transmission data and analysis data using the same communication path. Further, the battery management device 206 may be a different device from the analysis data transmission unit 200. For example, the analysis data transmission unit 200 may be a device managed by the user who is using the battery module 202, and the battery management device 206 may be a device managed by a provider who provided the battery module 202 to the user. **In** this case, the analysis device 100 may transmit and receive transmission data and analysis data using different communication paths. **In** another example, the battery management device 206 and the analysis data transmission unit 200 may both be devices managed by the user, or may both be devices managed by the provider.

The analysis device 100 of the present example includes a data acquisition unit 102, a data analysis unit 104, and a data transmission unit 106. The analysis device 100 may further include an analysis data recording unit 108. The data acquisition unit 102 acquires analysis data via the network 12. The data acquisition unit 102 may record the acquired analysis data in the analysis data recording unit 108. The analysis data recording unit 108 records the analysis data for each identification data.

The data analysis unit 104 analyzes the characteristics related to the charging capacity of at least one of the battery cells 204 based on the analysis data acquired by the data acquisition unit 102. The data analysis unit 104 may sequentially analyze the analysis data acquired by the data acquisition unit 102, or may read the analysis data from the analysis data recording unit 108 and analyze the read data.

The data transmission unit 106 transmits transmission data corresponding to an analysis result obtained by the data analysis unit 104 to the battery management device 206 via the network 12. The data transmission unit 106 may determine a transmission destination of the transmission data based on the identification data included in the analysis data used for the analysis by the data analysis unit 104. For example, the data transmission unit 106 may store therein in advance correspondence information in which the identification data and the transmission destination are associated with each other. Further, the analysis data may also include information that designates a transmission destination of the transmission data. **In** this case, the battery management device 206 may notify the analysis data transmission unit 200 of the information that designates the transmission destination.

According to the analysis system 10 of the present example, since the analysis device 100 is not provided for each battery module 202, costs of the battery modules 202 can be reduced. Further, performance of the analysis device 100 is improved, and thus an analysis of high accuracy can be performed with ease.

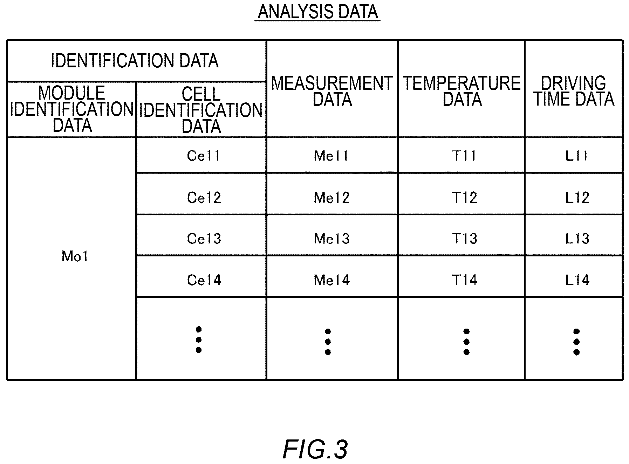

Fig. 3 shows an example of the analysis data. In the example of Fig. 3, one piece of analysis data includes analysis data related to one battery module 202. In another example, one piece of analysis data may include analysis data related to the plurality of battery modules 202.

The analysis data includes identification data and measurement data Me. The identification data includes at least one of module identification data Mo or cell identification data Ce. In the analysis data in the example of Fig. 3, the module identification data Mo and the cell identification data Ce are associated with each other. In this case, the data analysis unit 104 may analyze the characteristics related to the charging capacity of the battery cell 204 for each battery module 202. As an example, the data analysis unit 104 may analyze variations in the capacities of the battery cells 204 included in the battery module 202.

The measurement data Me is data for each battery cell 204. The analysis data recording unit 108 may record the measurement data acquired over time by the data acquisition unit 102, in association with the identification data. When the identification data includes the cell identification data Ce, the measurement data Me is associated with the cell identification data Ce. In this case, the data analysis unit 104 analyzes the measurement data Me for each cell identification data Ce, and analyzes the characteristics related to the charging capacities of the individual battery cells 204.

When the identification data does not include the cell identification data Ce, each measurement data Me is associated with common module identification data Mo. In this case, the data analysis unit 104 analyzes each measurement data Me and analyzes the characteristics related to the charging capacities of the battery cells 204. Note that when the analyzed characteristics do not specify which battery cell 204 the characteristics belong to, the data analysis unit 104 analyzes at least one of a maximum value, minimum value, average value, or the like of the capacities of the battery cells 204 included in the battery module 202, for example.

In the example of Fig. 3, the analysis data further includes temperature data T and driving time data L. The temperature data T indicates a temperature of the battery cell 204 or the battery module 202 when the measurement data is measured. The temperature data T may indicate a peripheral temperature of the battery module 202 when the measurement data is measured. The temperature data T may be common data with respect to the battery cells 204 in the battery module 202.

The driving time data L may indicate a cumulative driving time of each of the battery cells 204. The driving time may be an elapsed time since the battery cell 204 is started to be used, or may be a cumulative time obtained by accumulating a time during which the battery cell 204 is charged or discharged. Alternatively, the number of charging/discharging times of the battery cell 204 may be used as the driving time. Alternatively, the driving time data L may indicate a cumulative driving time of the battery module 202. The driving time data L may be data for each battery cell 204, or may be common data with respect to the battery cells 204 in the battery module 202.

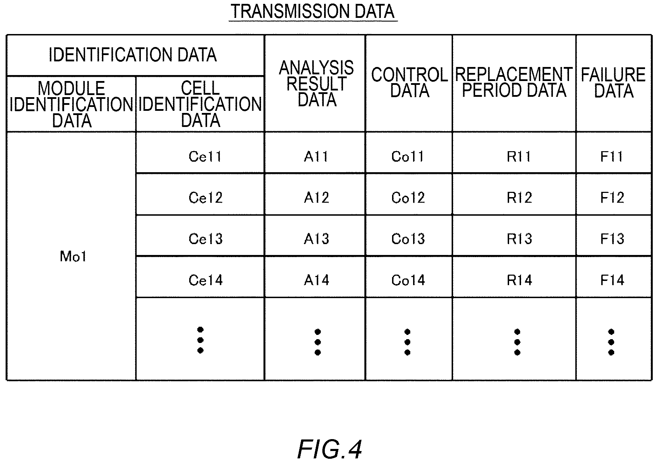

Fig. 4 shows an example of the transmission data. In the example of Fig. 4, one piece of transmission data includes data related to one battery module 202. In another example, one piece of transmission data may include data related to the plurality of battery modules 202.

The transmission data may include identification data. The identification data includes at least one of the module identification data Mo or the cell identification data Ce.

The transmission data may include analysis result data A. The analysis result data A is data related to the capacity of each of the battery cells 204, for example. In another example, the analysis result data A is data indicating at least one of the maximum value, minimum value, or average value of the capacities of the one or more battery cells 204 included in the battery module 202.

The transmission data may include control data Co. The control data Co is data used for controlling charging and discharging of the one or more battery cells 204 included in the battery module 202. The control data Co may designate at least one of a charge amount, a discharge amount, a charge timing, a discharge timing, a charge rate, or a discharge rate of each of the battery cells 204. The data analysis unit 104 may generate the control data Co based on the analysis result on the capacity of each of the battery cells 204. For example, the data analysis unit 104 generates control data Co for reducing capacity variations among the one or more battery cells 204 in the battery module 202. The data analysis unit 104 may generate the control data Co when a difference between a maximum value and minimum value of remaining capacities of the plurality of battery cells 204 included in the battery module 202 becomes equal to or larger than a predetermined threshold value. Accordingly, it is possible to suppress a situation where capacity variations among the battery cells 204 become too large.

The transmission data may include replacement time data R. The data analysis unit 104 may calculate a time to replace each of the battery cells 204 based on the analysis result on the capacity of each of the battery cells 204. As an example, the data analysis unit 104 may calculate a deterioration rate of each of the battery cells 204 based on a history of measurement data recorded in the analysis data recording unit 108, and estimate a replacement time based on the deterioration rate. The deterioration of the battery cell 204 can be calculated from deterioration of, for example, the full charge capacity, the interpolar voltage, the output current, or the like. The data analysis unit 104 may calculate a time at which the characteristics of the battery cell 204 fall below a predetermined reference value, as the replacement time of the battery cell 204. The replacement time data R may be data for each battery cell 204. In another example, the replacement time data R may be data for each battery module 202. In this case, of the replacement times of the battery cells 204 included in the battery module 202, the data analysis unit 104 may use the earliest replacement time as the replacement time of the battery module 202.

The transmission data may include failure data F. The data analysis unit 104 may judge whether a failure has occurred in each of the battery cells 204 based on the analysis result on the capacity of each of the battery cells 204. As an example, the data analysis unit 104 judges whether a failure has occurred in each of the battery cells 204 based on a temporal change of the characteristics such as the full charge capacity, of each of the battery cells 204. The data analysis unit 104 may judge that a failure has occurred in the battery cell 204 when a difference between a characteristics value calculated last time and a characteristics value calculated this time exceeds a predetermined reference value. The failure data F may be data for each battery cell 204. In another example, the failure data F may be data for each battery module 202. In this case, the data analysis unit 104 may judge that a failure has occurred in the battery module 202 when a failure occurs in any of the battery cells 204 included in the battery module 202.

The transmission data may include at least one of the analysis result data, the control data, the replacement time data, or the failure data. The transmission data may also include data other than these.

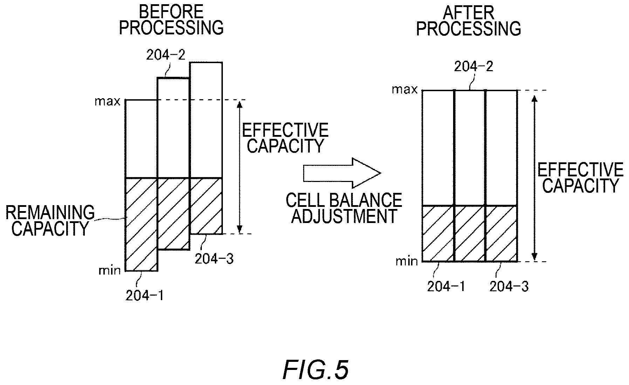

Fig. 5 illustrates variations in the remaining capacities of the battery cells 204 included in the battery module 202. Fig. 5 will be described using three battery cells 204-1, 204-2, and 204-3, but the number of battery cells 204 included in the battery module 202 is not limited to three. In Fig. 5, each of the battery cells 204 is rectangular. An upper end max of the rectangle indicates an upper limit value of the remaining capacity (i.e., full charge capacity) of the battery cell 204, and a lower end min indicates a lower limit value of the remaining capacity of the battery cell 204. The battery cell 204 is charged and discharged between the upper limit max and the lower limit min for preventing overcharge and over-discharge from occurring. In Fig. 5, the remaining capacity of each of the battery cells 204 is hatched with oblique lines.

As shown in the diagram of Fig. 5 showing a state before processing, variations may be caused in the remaining capacities of the battery cells 204 included in the battery module 202. For example, variations are caused in the remaining capacities of the battery cells 204 when natural discharge rates of the battery cells 204 differ.

The plurality of battery cells 204 of the present example are charged simultaneously. Therefore, when variations are caused in the remaining capacities, charging only by an amount corresponding to the battery cell 204 having a smallest available capacity is carried out in each of the battery cells 204, and thus not all the battery cells 204 can be charged to the upper limit max. Similarly, when the plurality of battery cells 204 are simultaneously discharged with respect to loads thereof, each of the battery cells 204 can be discharged only by an amount corresponding to the battery cell 204 having the smallest remaining capacity, and thus not all the battery cells 204 can be discharged to the lower limit min. Therefore, effective capacities of the plurality of battery cells 204 decrease according to a variation amount of the remaining capacities.

The analysis device 100 may analyze the remaining capacity of each of the battery cells 204. The battery management device 206 may charge and discharge each of the battery cells 204 and adjust a cell balance so that the variations in the remaining capacities of the battery cells 204 are reduced. Note that in the present example, the battery cells 204 are discharged to adjust a cell balance. For example, in Fig. 5, the battery cells 204 having relatively large remaining capacities are discharged. In another example, the battery cells 204 may be charged to adjust the cell balance. For example, the battery cells 204 having relatively small remaining capacities may be charged. Alternatively, the cell balance may be adjusted by combining the discharge and charge described above. The diagram of Fig. 5 showing a state after processing shows an effective capacity of the battery cells 204 after the cell balance is adjusted. The effective capacity increases by reducing the variations in the remaining capacities of the battery cells 204. The data analysis unit 104 may estimate an increase amount of the effective capacity by performing cell balance processing. The data transmission unit 106 may transmit transmission data indicating the estimated increase amount of the effective capacity to the battery management device 206.

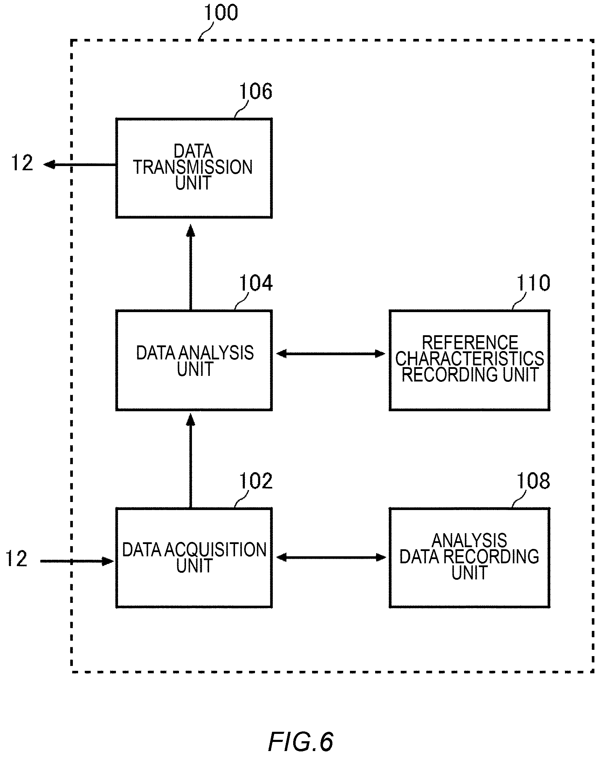

Fig. 6 shows another configuration example of the analysis device 100. The analysis device 100 of the present example accurately analyzes the capacity of each of the battery cells 204. As the analysis accuracy of the data analysis unit 104 regarding the remaining capacity becomes higher, the cell balance adjustment can be executed with higher accuracy, and it becomes easier to increase the effective capacity. The analysis device 100 of the present example further includes a reference characteristics recording unit 110 with respect to the example shown in Fig. 2. Other configurations are similar to those of the example described with reference to Fig. 2.

The reference characteristics recording unit 110 records predetermined reference characteristics. The data analysis unit 104 analyzes the capacity of the battery cell 204 based on the characteristics calculated from the measurement data and the reference characteristics.

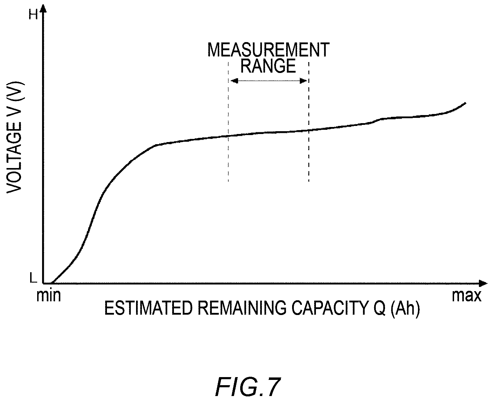

Fig. 7 illustrates an example of the measurement data included in the analysis data. The measurement unit 208 of the present example measures capacitance-voltage characteristics that indicate a relationship between the interpolar voltage, which is obtained during charging or discharging of each of the battery cells 204, and an estimated remaining capacity, and generates measurement data. The measurement unit 208 may measure the capacitance-voltage characteristics during an actual operation of the battery module 202. For example, during an actual operation means a state where the battery module 202 supplies electrical power to a load or a state where surplus electrical power of a power generation device is supplied to the battery module 202. The measurement unit 208 may calculate the remaining capacity of each of the battery cells 204 from an integrated amount of a current output from the battery module 202 and a current supplied to the battery module 202. The remaining capacity of the battery cell 204 decreases by an amount corresponding to the amount of current output from the battery module 202, and the remaining capacity of the battery cell 204 increases by an amount corresponding to the amount of current charged to the battery module 202.

The measurement unit 208 of the present example measures the capacitance-voltage characteristics within a predetermined measurement range of an estimated remaining capacity Q. The measurement range is a part of a range of the estimated remaining capacity from the lower limit min to the upper limit max. It is preferable for the measurement range not to include the lower limit min and upper limit max of the estimated remaining capacity. Accordingly, the measurement unit 208 can measure the capacitance-voltage characteristics while avoiding a situation where the battery cells 204 are close to an overcharged state or an over-discharged state. A size of the measurement range may be half or less or 1/4 or less of the size of the range from the lower limit min to the upper limit max. By reducing the size of the measurement range, the capacitance-voltage characteristics can be acquired in a short time, and the capacitance-voltage characteristics are acquired easily even during an actual operation of the battery module 202. Further, by reducing the size of the measurement range, it becomes easy to measure, even in a state where there are variations in the remaining capacities of the plurality of battery cells 204, the capacitance-voltage characteristics without causing overcharging or over-discharging of each of the battery cells 204.

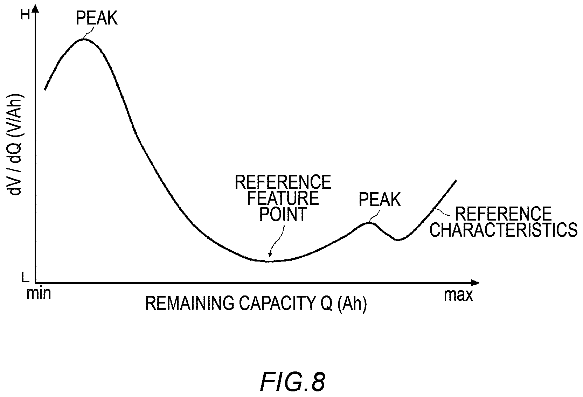

Fig. 8 shows an example of the reference characteristics recorded by the reference characteristics recording unit 110. The reference characteristics correspond to characteristics obtained by differentiating the capacitance-voltage characteristics of the battery cell 204 by the remaining capacity. The reference characteristics of the battery cell 204 can be determined in advance based on an electrode material of the battery cell 204, or based on a manufacturer or model of the battery cell 204 or the battery module 202. The reference characteristics recording unit 110 may record a plurality of types of reference characteristics in accordance with a plurality of types of electrode materials. It is preferable for the data analysis unit 104 to analyze the battery cell 204 using the reference characteristics corresponding to the electrode material of the battery cell 204 as the analysis target. The data acquisition unit 102 may acquire analysis data indicating the electrode material of the battery cell 204. Further, the analysis data recording unit 108 may record information indicating the electrode material of the battery cell 204 in association with at least one of the battery module 202 or the battery cell 204.

For example, when the battery cell 204 is a lithium battery, lithium ions move between the positive electrode and the negative electrode during charging and discharging. Lithium ions are inserted into each electrode active material (also referred to as reduction) or lithium ions are desorbed (also referred to as oxidization), with the result that a crystal structure of the electrode active material changes. This change in the crystal structure is called "phase transition", which is a phenomenon that occurs near a potential unique to the electrode active material defined electrochemically. By the phase transition phenomenon, peaks appear at predetermined positions in the reference characteristics.

As described above, it is possible to determine the capacitance-voltage characteristics of the battery cell 204 according to the type of the electrode active material, and also determine the reference characteristics as derivation characteristics thereof. The reference characteristics may be acquired by premeasuring characteristics of one or more battery cells as a reference. Alternatively, the reference characteristics may be acquired in advance by a simulation. A method of acquiring the reference characteristics may be similar to that described in Patent Document 1.

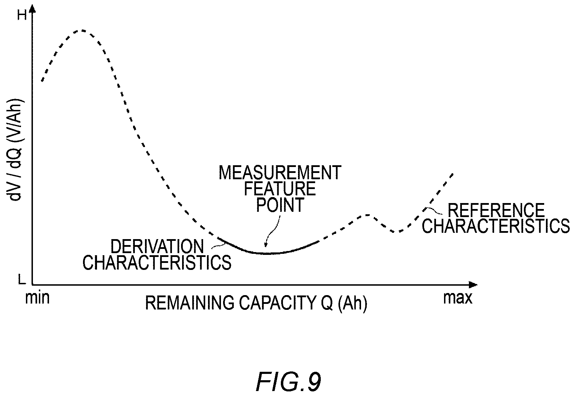

Fig. 9 illustrates a method of calculating the remaining capacity of the battery cell 204 using the reference characteristics and the derivation characteristics. In Fig. 9, the derivation characteristics in the measurement range shown in Fig. 7 are indicated by a solid line, and the reference characteristics are indicated by dashes. The data analysis unit 104 of the present example performs a parallel shift of the derivation characteristics to a position at which an error between the derivation characteristics and the reference characteristics becomes minimum. The data analysis unit 104 may determine the position by the method of least squares. An amount by which the derivation characteristics are moved in an axial direction of the remaining capacity Q corresponds to an error between the estimated remaining capacity of the battery cell 204 described in Fig. 7 and the actual remaining capacity. The data analysis unit 104 may calculate the actual remaining capacity of the battery cell 204 from the error and a current estimated remaining capacity of the battery cell 204. The data analysis unit 104 may calculate the actual remaining capacity of the battery cell 204 by a method similar to the method disclosed in Patent Document 1.

As shown in Fig. 8, each reference characteristics may include a reference feature point. The reference feature point is a point that should be included in the derivation characteristics for performing fitting of the reference characteristics and the derivation characteristics with high accuracy. The reference feature point may be a point at which a fluctuation corresponding to a measurement condition such as a temperature, is smaller than that of other points. The reference feature point may be arranged in a slope portion between the peaks of the reference characteristics. The reference feature point may be a point at which a local minimum value of the reference characteristics is obtained. The reference feature point may be an apex of a peak of the reference characteristics. A plurality of reference feature points may be set in the reference characteristics. The reference characteristics recording unit 110 may record a value of the remaining capacity at the reference feature point, for each reference characteristics.

The measurement unit 208 may measure the characteristics of the battery cell 204 within a measurement range including any of the reference feature points (i.e., range of estimated remaining capacity). The position of each reference feature point may be notified to the battery management device 206 from the analysis device 100. Further, the analysis device 100 may notify the battery management device 206 of the measurement range including any of the reference feature points. By acquiring the measurement data within the measurement range, a measurement feature point corresponding to the reference feature point is included in the derivation characteristics of the measurement data.

The data analysis unit 104 may analyze the capacity of the battery cell 204 based on the measurement feature point in the derivation characteristics of the battery cell 204 and the reference feature point in the reference characteristics. As described above, the data analysis unit 104 may perform a parallel shift of the derivation characteristics such that the position of the measurement feature point and the position of the reference feature point match.

Although the remaining capacity of the battery cell 204 has been analyzed in the present example, the data analysis unit 104 may also analyze a full charge capacity of the battery cell 204. In this case, the data analysis unit 104 may use the derivation characteristics obtained by differentiating the capacitance-voltage characteristics by a voltage. Further, the reference characteristics recording unit 110 may record the reference characteristics corresponding to the derivation characteristics. The data analysis unit 104 may adjust at least one of the position or amplitude of the reference characteristics so that an error with respect to the derivation characteristics becomes minimum. By integrating the adjusted reference characteristics within a predetermined range of a working voltage, the full charge capacity of the battery cell 204 can be calculated. The data analysis unit 104 may calculate the full charge capacity of the battery cell 204 by a method similar to the method disclosed in Patent Document 1. The data analysis unit 104 may calculate a ratio of the remaining capacity to the full charge capacity (also referred to as SOC).

Note that when the analysis data includes temperature data indicating a temperature of the battery cell 204 obtained at a time of measuring the capacitance-voltage characteristics, the data analysis unit 104 may correct the analysis that uses the derivation characteristics, based on the temperature of the battery cell 204. The capacitance-voltage characteristics of the battery cell 204 may fluctuate depending on the temperature of the battery cell 204. The data analysis unit 104 may correct a characteristics fluctuation due to the temperature of the battery cell 204 and analyze the characteristics of the battery cell 204. Specifically, the data analysis unit 104 may correct at least one of the derivation characteristics or the reference characteristics using the temperature. According to the temperature, the data analysis unit 104 may shift the derivation characteristics or the reference characteristics in an axial direction of the remaining capacity. The data analysis unit 104 may correct an amplitude of the derivation characteristics or the reference characteristics according to the temperature. Correction information indicating the way to correct each characteristics according to the temperature of the battery cell 204 may be preset in the data analysis unit 104. The correction information can be generated by premeasuring how the capacitance-voltage characteristics fluctuate according to the temperature fluctuation.

The data analysis unit 104 can analyze the capacity of the battery cell 204 highly accurately by the method described with reference to Figs. 7 to 9. Note that the analysis by the data analysis unit 104 is not limited to the content described with reference to Figs. 7 to 9. The data analysis unit 104 may analyze information related to the capacity of the battery cell 204 using a well-known technique. For example, the data analysis unit 104 can calculate the remaining capacity based on the interpolar voltage of the battery cell 204. A relationship between the interpolar voltage and the remaining capacity may be provided in advance to the data analysis unit 104. The data analysis unit 104 may estimate the remaining capacity of the battery cell 204 by integrating the output current and charging current of the battery cell 204.

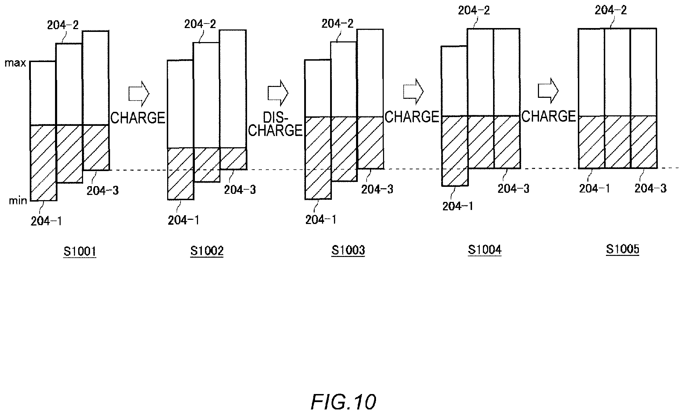

Fig. 10 illustrates processing for reducing variations in the remaining capacities of the plurality of battery cells 204 included in the battery module 202. The present example will be described using three battery cells 204, but the number of battery cells 204 is not limited to three. As described above, the data analysis unit 104 may generate transmission data for charging and discharging the battery cells 204. The charging and discharging of the battery cells 204 may be performed by the battery management device 206 based on control data Co included in the transmission data, or may be performed by the battery management device 206 based on analysis result data A included in the transmission data.

An initial step S1001 indicates a state where the remaining capacities of the battery cells 204 vary. Note that in Fig. 10, the remaining capacities are hatched with oblique lines similar to Fig. 5. Next, in a first measurement step S1002, all the battery cells 204 may be discharged by the same amount. While discharging the battery cells 204, the measurement unit 208 measures characteristics of each of the battery cells 204, such as the interpolar voltage and the discharging current. Next, in a second measurement step S1003, all the battery cells 204 may be charged by the same amount. While charging the battery cells 204, the measurement unit 208 measures characteristics of each of the battery cells 204, such as the interpolar voltage and the charging current. By the processing of S1002 and S1003, the measurement unit 208 can measure the capacitance-voltage characteristics of each of the battery cells 204. The measurement unit 208 may calculate an estimated remaining capacity of each of the battery cells 204 by sequentially integrating the discharging current or the charging current.

The measurement unit 208 may also measure the capacitance-voltage characteristics during an actual operation of the battery module 202 in place of the processing of S1002 and S1003. That is, the measurement unit 208 may also measure the voltages and currents of the battery cells 204 while a current is supplied from the battery module 202 to a load or while surplus electrical power of the power generation device is being charged to the battery module 202.

Next, in a discharging step S1004, at least one of the battery cells 204 in which the remaining capacity is not the smallest is discharged, to reduce a difference in the remaining capacities with respect to the battery cell 204 having the smallest remaining capacity. In S1004, all the battery cells 204 except for the battery cell 204 having the smallest remaining capacity may be discharged by the same amount. In the example of Fig. 10, the remaining capacity of the battery cell 204-3 is the smallest. In S1004, the battery cells 204-1 and 204-2 are discharged. In the discharging step S1004, the battery cells 204-1 and 204-2 may be discharged such that, out of the battery cells 204-1 and 204-2 except for the battery cell 204-3, the remaining capacity of the battery cell 204-2 having the smallest remaining capacity becomes equal to the remaining capacity of the battery cell 204-3.

Next, in a discharging step S1005, processing similar to that of the discharging step S1004 is repeated. That is, at least one of the battery cells 204 in which the remaining capacity is not the smallest is discharged so as to reduce a difference in the remaining capacities with respect to the battery cell 204 having the smallest remaining capacity. In the present example, the remaining capacities of the battery cells 204-3 and 204-2 are the smallest. Therefore, in the present example, the battery cell 204-1 is discharged. Also in S1005, the battery cell 204-1 may be discharged such that the remaining capacity of the battery cell 204-1 becomes equal to the smallest remaining capacity.

By repeating the discharging step described in S1004 or S1005, the remaining capacities of all the battery cells 204 can be made equal to one another. Accordingly, the effective capacity of the battery module 202 can be increased.

In S1002 to S1005, it is preferable to control charging and discharging of the battery cells 204 so that the remaining capacity of any of the battery cells 204 does not become the upper limit max and the lower limit min of each of the battery cells 204. Accordingly, it is possible to suppress a situation where the battery cells 204 are over-discharged or overcharged, and suppress deterioration of the battery cells 204 in the processing described with reference to Fig. 10. In a case where the battery cell 204 is a lithium ion battery in particular, deterioration tends to be promoted when left in a state where the remaining capacity is close to the upper limit max. Further, when left in a state where the remaining capacity is close to the lower limit min, natural discharge tends to be promoted so as to cause over-discharge, thereby promoting deterioration. Therefore, when the battery cell 204 is a lithium ion battery, the effect of deterioration suppression by the processing described with reference to Fig. 10 may become prominent.

Note that when the accuracy in analyzing the capacity of the battery cell 204 is low, each of the battery cells 204 may be set to a full charge state for matching the remaining capacities of the battery cells 204. In contrast, by using the method described with reference to Figs. 7 to 9, the capacity of each of the battery cells 204 can be analyzed accurately. Therefore, as described with reference to Fig. 10, the cell balance can be adjusted without setting the battery cells 204 to a full charge state. Further, since the measurement only needs to be performed within a partial measurement range in the method described with reference to Figs. 7 to 9, it becomes easy to perform control such that the remaining capacity of the battery cell 204 does not become the upper limit max or the lower limit min. Furthermore, since each of the battery cells 204 is not set to the full charge state according to the method described with reference to Fig. 10, the remaining capacities can be balanced in a short processing time. Therefore, an effect on the actual operation of the battery module 202 is small. By executing the processing of Fig. 10 at a high frequency, the effective capacity of the battery module 202 can be kept high.

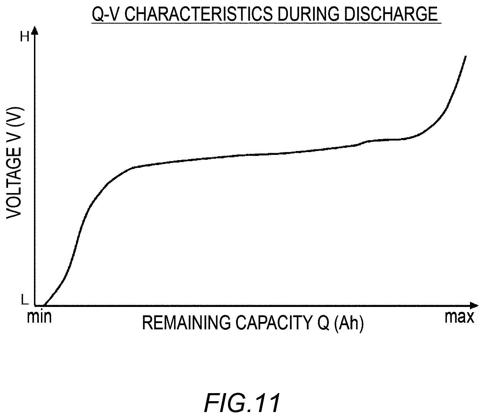

Fig. 11 shows an example of the capacitance-voltage characteristics during discharging of the battery cell 204. Note that the capacitance-voltage characteristics shown in Fig. 7 are an example of the capacitance-voltage characteristics during charging of the battery cell 204. The capacitance-voltage characteristics during discharging are capacitance-voltage characteristics that have been measured while lowering the remaining capacity of the battery cell 204, and the capacitance-voltage characteristics during charging are capacitance-voltage characteristics that have been measured while raising the remaining capacity of the battery cell 204. As shown in Figs. 7 and 11, the capacitance-voltage characteristics of the battery cell 204 may differ between the time of charging and the time of discharging. The fact that the capacitance-voltage characteristics may differ between the time of charging and the time of discharging of the battery cell 204 has been confirmed experimentally.

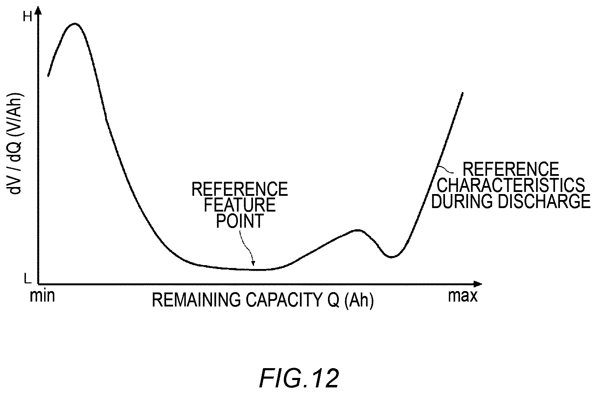

Fig. 12 shows an example of the reference characteristics during discharging of the battery cell 204. Similar to the capacitance-voltage characteristics, also the reference characteristics obtained by differentiating the capacitance-voltage characteristics may differ between the time of charging and the time of discharging of the battery cell 204. The reference characteristics recording unit 110 may record at least one of the reference characteristics obtained when charging the battery cell 204 or the reference characteristics obtained when discharging the battery cell 204. In the present example, the reference characteristics recording unit 110 records both the reference characteristics during charging and the reference characteristics during discharging.

The data analysis unit 104 may select, based on which of data obtained during charging of the battery cell 204 or data obtained during discharging the measurement data Me of the battery cell 204 is, the reference characteristics to be compared with the derivation characteristics calculated from the measurement data Me. That is, when the measurement data Me is measurement data obtained during charging, the data analysis unit 104 selects the reference characteristics during charging. Alternatively, when the measurement data Me is measurement data obtained during discharging, the data analysis unit 104 selects the reference characteristics during discharging. It is preferable for the analysis data to include data that indicates which of the measurement data obtained during charging or the measurement data obtained during discharging the measurement data Me is.

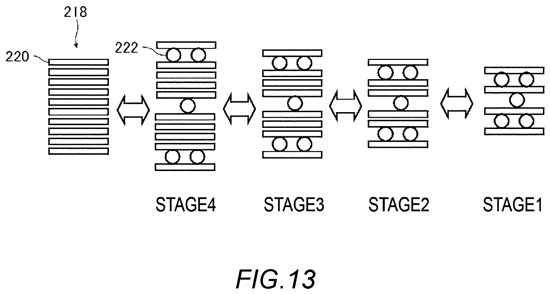

Fig. 13 illustrates an overview of the charging and discharging of the battery cell 204. In Fig. 13, a case where the battery cell 204 is a lithium ion battery will be described. A negative electrode 218 of the battery cell 204 includes a plurality of graphite layers 220. By charging and discharging the battery cell 204, lithium ions 222 are inserted between or desorbed from the graphite layers 220. A state of the negative electrode 218 corresponding to a density at which the lithium ions 222 are inserted between the graphite layers 220 is referred to as a stage. The capacitance-voltage characteristics change according to the stage of the negative electrode 218. One of the reasons why the capacitance-voltage characteristics of the battery cell 204 differ between the time of charging and the time of discharging is probably because operations of the lithium ions 222 differ between the time of insertion into the graphite layers 220 and the time of desorption from the graphite layers 220.

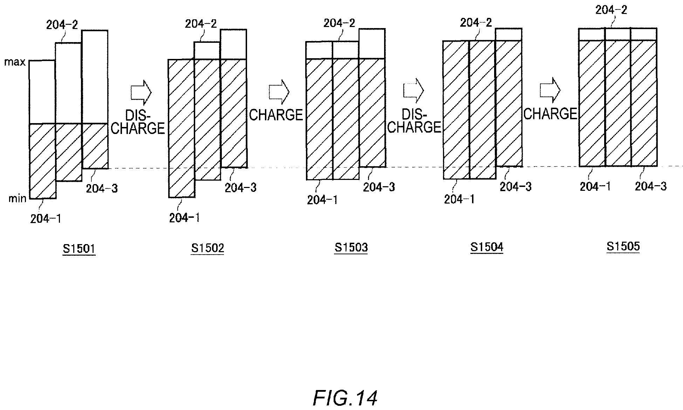

Fig. 14 illustrates another example of the cell balance processing. Also in the present example, the data analysis unit 104 may generate transmission data for charging and discharging the battery cell 204, similar to the example of Fig. 10. The charging and discharging of the battery cells 204 may be performed by the battery management device 206 based on the control data Co included in the transmission data, or may be performed by the battery management device 206 based on the analysis result data A included in the transmission data.

An initial step S1501 shows a state where the remaining capacities of the battery cells 204 vary. Next, in a charging step S1502, each of the battery cells 204 is charged until the battery cell 204-1 having a largest remaining capacity is fully charged.

Next, in a discharging step S1503, the battery cell 204-1 that has been fully charged is discharged. In S1503, the battery cell 204-1 is discharged until the remaining capacity of the battery cell 204-2, which has the largest remaining capacity out of the battery cells 204 excluding the battery cell 204-1, matches the remaining capacity of the battery cell 204-1.

Next, in a charging step S1504, each of the battery cells 204 is charged until the battery cells 204-1 and 204-2 having the largest remaining capacities are fully charged.

Next, in a discharging step S1505, the battery cells 204-1 and 204-2 that have been fully charged are discharged. In S1505, the battery cells 204-1 and 204-2 are discharged until the remaining capacities of the battery cells 204-1 and 204-2 and the remaining capacity of the battery cell 204-3, which has the largest remaining capacity out of the rest of the battery cells 204, match. As described above, by repeating the charging step and the discharging step, the remaining capacities of all the battery cells 204 can be made equal to one another. Accordingly, the effective capacity of the battery module 202 can be increased.

Note that also in the example of Fig. 14, the data analysis unit 104 may analyze the capacity of the battery cell 204 by the method described with reference to Figs. 7 to 9, or may use other methods. The data analysis unit 104 may calculate the remaining capacity based on the interpolar voltage of the battery cell 204. The data analysis unit 104 may estimate the remaining capacity of the battery cell 204 by integrating the output current and charging current of the battery cell 204.

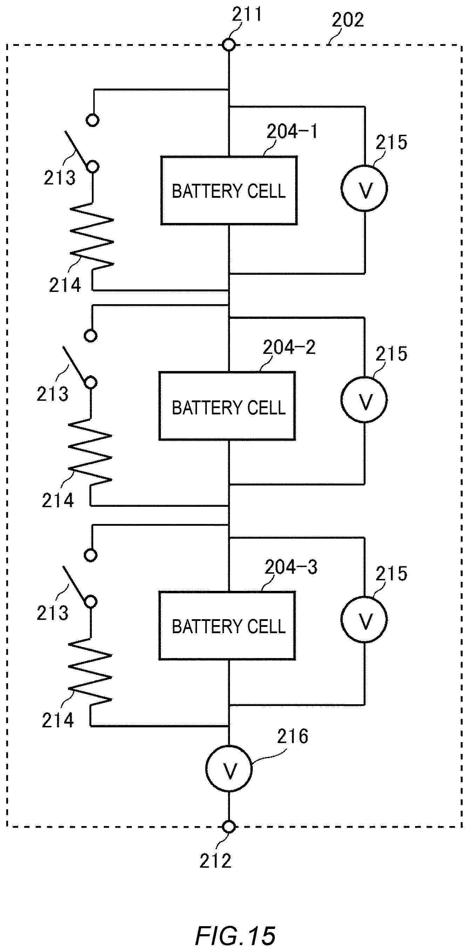

Fig. 15 illustrates an overview of the battery module 202. The battery module 202 of the present example includes a positive terminal 211, a negative terminal 212, and the plurality of battery cells 204 connect in series between both terminals. The battery module 202 further includes, with respect to each of the battery cells 204, a discharging switch 213, a discharge resistance 214, and a voltmeter 215. The discharging switch 213 switches whether to connect a positive electrode and a negative electrode of the battery cell 204 via the discharge resistance 214. By setting the discharging switch 213 in an ON state, the corresponding battery cell 204 can be discharged. The voltmeter 215 measures the interpolar voltage of the corresponding battery cell 204. The voltmeter 215 functions as a part of the measurement unit 208.

The battery module 202 may further include an ammeter 216 provided in series with respect to the plurality of battery cells 204. The ammeter 216 measures a current flowing through the plurality of battery cells 204. The ammeter 216 functions as a part of the measurement unit 208.

In the battery module 202 of the present example, the individual battery cells 204 can be selected for discharging. Further, when charging the plurality of battery cells 204, the battery management device 206 connects a charging power source to the positive terminal 211 and the negative terminal 212. Therefore, the plurality of battery cells 204 are charged at the same time. According to the method described with reference to Fig. 10 or 14, the variations of the remaining capacities in the battery module 202 having the configuration shown in Fig. 15 can be reduced easily.

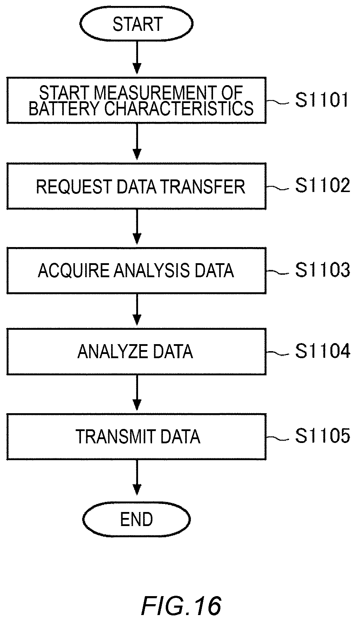

Fig. 16 is a flowchart showing an operation example of the analysis device 100. The analysis device 100 of the present example generates correction data for correcting the remaining capacity of each of the battery cells 204 based on the analysis data, and transmits it to the battery management device 206. Other operations are similar to those of the examples described with reference to Figs. 1 to 15.

First, in a measurement start step S1101, the data transmission unit 106 causes the battery management device 206 to start a measurement of the characteristics of the battery cells 204. The data transmission unit 106 may transmit transmission data that becomes a trigger to start the measurement via the network 12. The data transmission unit 106 may transmit transmission data that designates the measurement range shown in Fig. 7. Next, in a transfer request step S1102, the data transmission unit 106 requests the battery management device 206 to transfer analysis data via the network 12.

Next, in a data acquisition step S1103, the data acquisition unit 102 acquires analysis data from the analysis data transmission unit 200 via the network 12. Next, in a data analysis step S1104, the data analysis unit 104 analyzes characteristics related to the charging capacity of at least one of the battery cells 204 based on the analysis data acquired in the data acquisition step S1103. The data analysis unit 104 of the present example may calculate an error between the estimated remaining capacity of the battery cell 204 estimated by the measurement unit 208 and the remaining capacity calculated by the analysis. Next, in a result transmission step S1105, the data transmission unit 106 transmits transmission data corresponding to the analysis result obtained in the data analysis step S1104 to the battery management device 206 via the network 12. The transmission data of the present example includes correction data for correcting the estimated remaining capacity.

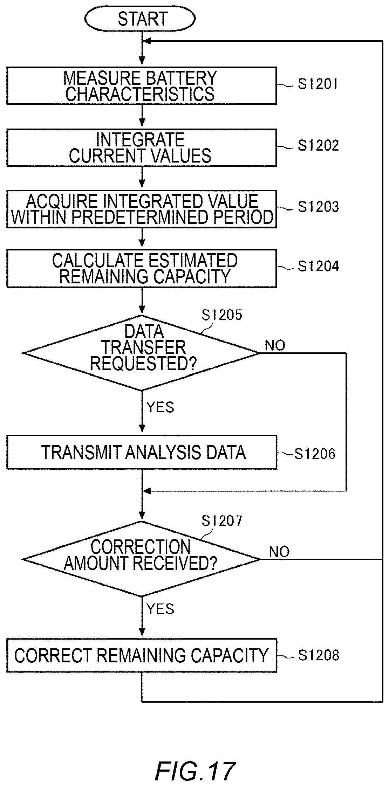

Fig. 17 is a flowchart showing an operation example of the battery management device 206, the measurement unit 208, and the analysis data transmission unit 200. The battery management device 206 of the present example corrects the estimated remaining capacity of each of the battery cells 204 based on an analysis result obtained by the analysis device 100. Accordingly, accuracy of the estimated remaining capacity managed by the battery management device 206 can be improved. Other operations are similar to those of the examples described with reference to Figs. 1 to 15.

First, in the analysis system 10 of the present example, in a measurement step S1201, the measurement unit 208 generates measurement data obtained by measuring characteristics related to charging and discharging of one or more battery cells 204 included in the battery module 202. The measurement unit 208 may measure the characteristics of each of the battery cells 204 so as to include the measurement range designated by the transmission data. The battery management device 206 may cause the measurement unit 208 to start the measurement according to the trigger received from the analysis device 100 in the measurement start step S1101 of Fig. 16. The measurement step S1201 corresponds to S1002 and S1003 in Fig. 10.

When the battery cells 204 are charged and discharged in order to measure the characteristics of the battery cells 204, the measurement unit 208 integrates current values obtained during charging and discharging of the battery cells 204 (S1202). Further, the measurement unit 208 acquires an integrated value of the current values at each timing within a predetermined period (S1203). The measurement unit 208 calculates an estimated value of the remaining capacity at each timing based on the acquired integrated value (S1204). Accordingly, the capacitance-voltage characteristics of the battery cells 204 in the predetermined measurement range can be acquired as shown in Fig. 7.

Next, in a first judgment step S1205, the battery management device 206 judges whether a transfer request for analysis data has been received from the analysis device 100. When the transfer request is received, the battery management device 206 causes the analysis data transmission unit 200 to transmit the analysis data (S1206). When the transfer request is not received, the battery management device 206 performs next processing without performing the processing of S1206.

Next, in a second judgment step S1207, the battery management device 206 judges whether correction data for correcting the estimated remaining capacity has been received from the analysis device 100. When the correction data is received, the battery management device 206 corrects the estimated remaining capacity (S1208). When the correction data is not received, the battery management device 206 repeats the processing from S1201.

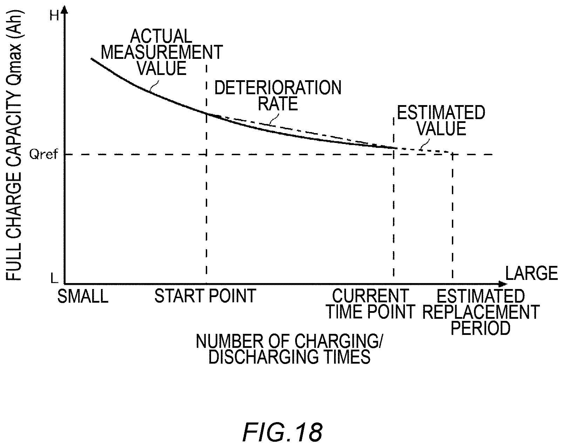

Fig. 18 shows another example of the analysis content by the data analysis unit 104. The data analysis unit 104 of the present example calculates a deterioration rate of the battery cell 204 from the derivation characteristics of the battery cell 204. The data analysis unit 104 may calculate the deterioration rate of the battery cell 204 from a change of the full charge capacity of the battery cell 204. The data analysis unit 104 may calculate the number of charging/discharging times of the battery cell 204 from a usage history of the battery cell 204, and calculate the deterioration rate based on a deterioration amount of the full charge capacity with respect to the number of charging/discharging times. The data analysis unit 104 may use, as the number of charging times of the battery cell 204, a quotient obtained by dividing the integrated value of the charging current of the battery cell 204 within a usage period by a predetermined reference value. The data analysis unit 104 may use, as the number of discharging times of the battery cell 204, a quotient obtained by dividing the integrated value of the discharging current of the battery cell 204 within the usage period by a predetermined reference value. As these reference values, a rating capacity of the battery cell 204 may be used. The data analysis unit 104 may use a sum of the number of charging times and the number of discharging times as the number of charging/discharging times.

Fig. 18 shows a graph in which a horizontal axis represents the number of charging/discharging times, and a vertical axis represents the full charge capacity. The data analysis unit 104 may calculate a temporal change of the full charge capacity of each of the battery cells 204 based on the time series measurement data recorded by the analysis data recording unit 108. In this case, the measurement data may include respective integrated values of the charging current and the discharging current during a period from a start of the use of the battery cell 204 to a timing of measuring the characteristics of the battery cell 204.

The data analysis unit 104 may calculate the deterioration rate of the battery cell 204 based on a change amount of the full charge capacity from a predetermined start point to a current time point. The start point may be set at any timing from the time point the battery cell 204 is started to be used to the current time point. The deterioration rate of the present example is a deterioration amount of the full charge capacity per unit number of charging/discharging times.

The data analysis unit 104 may also estimate the deterioration rate of the full charge capacity from the current time point onward, from an actual measurement value of the temporal change of the full charge capacity. The data analysis unit 104 may use the deterioration rate from a predetermined start point to the current time point, as the deterioration rate from the current time point onward.

In another example, the data analysis unit 104 may estimate the deterioration rate from the current time point onward from the value of the full charge capacity at the current time point. A relationship between the value of the full charge capacity and the deterioration rate from the current time point onward may be provided in advance to the data analysis unit 104. The relationship may be a designed value set by a manufacturer of the battery cells 204, or may be a relationship obtained statistically from performance of the same type of battery cells 204.

The data analysis unit 104 may generate replacement time data indicating a time to replace the battery cell 204 based on the analysis result on the analysis data. For example, the data analysis unit 104 estimates a time at which the full charge capacity falls below a predetermined reference value Qref based on the estimated value of the deterioration rate. The time may be expressed by a time that has elapsed since the current time point (for example, month, day, or time), or may be expressed by the number of charging/discharging times. The data analysis unit 104 may calculate the number of times charging and discharging have been performed per unit time, from the usage history of the battery cell 204. The data analysis unit 104 may calculate an elapsed time corresponding to the replacement time from the calculated relationship between the time and the number of charging/discharging times. The data analysis unit 104 may also generate, when the full charge capacity at the current time point falls below the predetermined reference value Qref, replacement time data indicating that a period before reaching the replacement time is 0 (i.e., replacement should be performed at current time point).

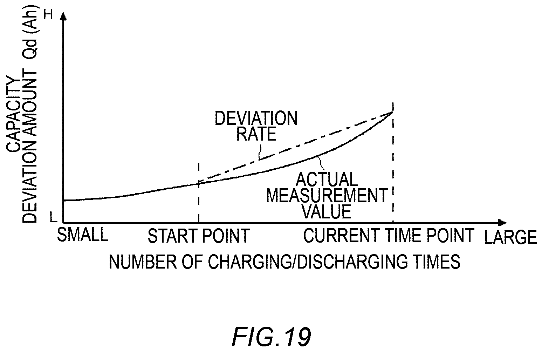

Fig. 19 shows another example of the analysis content by the data analysis unit 104. Based on a deviation amount of the charging capacities between two or more battery cells 204, that is calculated from the derivation characteristics of the two or more battery cells 204, the data analysis unit 104 of the present example calculates a deviation rate of the charging capacities between the two or more battery cells 204. The deviation amount may be used as the deterioration amount of the two or more battery cells 204. The charging capacity may be the remaining capacity at the time of starting the measurement of the characteristics of the battery cells 204 as shown in the initial step S1001 of Fig. 10 or the initial step S1501 of Fig. 14. The charging capacity may be the full charge capacity of the battery cell 204. Similar to the calculation of the deterioration rate, the data analysis unit 104 may calculate the number of charging/discharging times of the battery cell 204 from the usage history of the battery cell 204 recorded by the analysis data recording unit 108, and calculate the deviation rate based on a change of the deviation amount with respect to the number of charging/discharging times.

Fig. 19 shows a graph in which a horizontal axis represents the number of charging/discharging times, and a vertical axis represents a deviation amount of the charging capacities. The data analysis unit 104 may calculate a temporal change of the deviation amount of the charging capacities based on the time series measurement data recorded by the analysis data recording unit 108. The data analysis unit 104 may calculate a deviation rate of the charging capacities between the battery cells 204 based on a change of the deviation amount from a predetermined start point to the current time point.

The data analysis unit 104 may estimate the deviation rate from the current time point onward from an actual measurement value of the temporal change of the deviation amount. The data analysis unit 104 may use the deviation rate from a predetermined start point to the current time point, as the deviation rate from the current time point onward.

In another example, the data analysis unit 104 may estimate the deviation rate from the current time point onward from the value of the deviation amount at the current time point. A relationship between the value of the deviation amount and the deviation rate from the current time point onward may be provided in advance to the data analysis unit 104. The relationship may be a designed value set by a manufacturer of the battery cells 204, or may be a relationship obtained statistically from performance of the same type of battery cells 204.

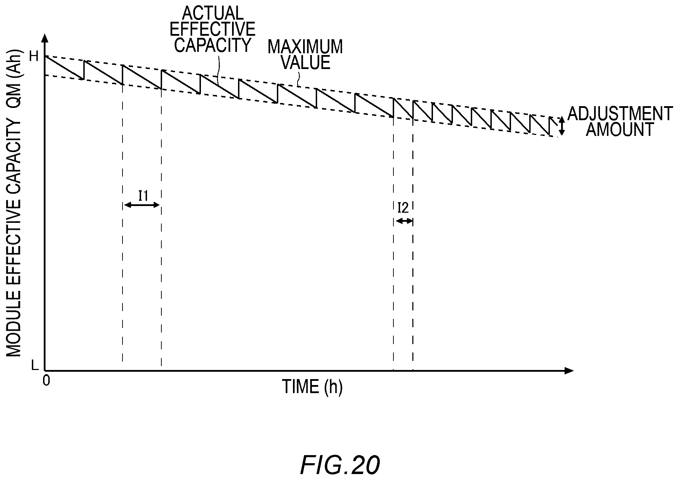

Fig. 20 shows a transition example of the effective capacity of the battery module 202. A maximum value of the effective capacity of the battery module 202 corresponds to a sum of the full charge capacities of the battery cells 204. Note that as described with reference to Fig. 4, when the remaining capacities of the respective battery cells 204 vary, the effective capacity of the battery module 202 becomes smaller than a maximum value thereof. In Fig. 20, the maximum value of the effective capacity is indicated by dashes, and an actual effective capacity is indicated by a solid line. In the present example, the maximum value of the effective capacity gradually decreases due to temporal deterioration of each of the battery cells 204.

When the variations in the remaining capacities among the battery cells 204 increase due to variations in natural discharge amounts or the like, the effective capacity of the battery module 202 gradually decreases. In the analysis system 10 of the present example, the cell balance processing on the remaining capacities of the battery cells 204, that has been described with reference to Fig. 10, is executed at predetermined time intervals I1. Therefore, the effective capacity of the battery module 202 recovers to a value close to the maximum value at each time interval I1.

By shortening the time intervals I1, an adjustment amount of the effective capacity in one cell balance processing can be made small. Therefore, it is possible to shorten a time required for the cell balance processing and thus shorten a time during which the battery module 202 cannot be actually operated.

The data analysis unit 104 may adjust the time intervals I based on the deviation rate of the charging capacities of two or more battery cells 204. The data analysis unit 104 may shorten the time intervals I when a difference between the calculated deviation rate and a predetermined designed value becomes large. The data analysis unit 104 may shorten the time intervals I when a tendency of the deviation among the charging capacities of the battery cells 204 changes. The change of the tendency of the deviation is, for example, a case where a deviation of the battery cells 204 different from the past becomes large. The data analysis unit 104 may set the time intervals I to become shorter as the deviation rate increases. Accordingly, an increase of the adjustment amount in one cell balance processing can be suppressed. In the example of Fig. 20, the data analysis unit 104 adjusts the time intervals to I2.

The data analysis unit 104 calculates measurement intervals to measure data related to the charging and discharging of two or more battery cells 204 according to the time intervals, so that the cell balance processing can be executed at the time intervals. As an example, the measurement interval is equal to the time interval. The data transmission unit 106 transmits transmission data corresponding to the measurement interval. The data transmission unit 106 may transmit transmission data that becomes a trigger for the measurement unit 208 to measure the characteristics of the battery cell 204 at timings corresponding to the measurement intervals. In another example, the data transmission unit 106 may transmit transmission data including data that indicates a length of the measurement intervals. In this case, the battery management device 206 causes the measurement unit 208 to measure the characteristics of the battery cell 204 at cycles corresponding to the measurement intervals. Further, the data analysis unit 104 may generate control data for controlling charging and discharging of the battery cell 204 according to the analysis result on the measurement data, and transmit the control data at timings corresponding to the time intervals.

The data analysis unit 104 may adjust the time intervals I based on the deterioration rate of the battery cell 204. The data analysis unit 104 may shorten the time intervals I when a difference between the calculated deterioration rate and a predetermined designed value becomes large. The data analysis unit 104 may shorten the time intervals I when the tendency of the deterioration of the charging capacities among the battery cells 204 changes. The change of the tendency of the deterioration is, for example, a case where the deterioration of the battery cells 204 different from the past becomes large.

As the battery cell 204 deteriorates, the variations in the remaining capacities of the battery cells 204 are likely to become large. The data analysis unit 104 may shorten the time intervals I as the deterioration rate of the battery cell 204 increases. The data analysis unit 104 may use an average value of the deterioration rates of the battery cells 204 included in the battery module 202, or use a worst value. Accordingly, an increase of the adjustment amount in one cell balance processing can be suppressed.

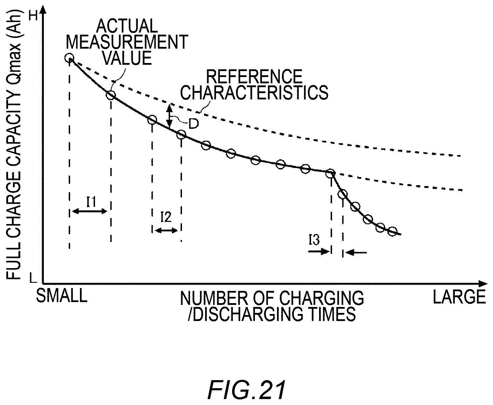

Fig. 21 shows an example of a deterioration detection of the battery cell 204. In the present example, the deterioration will be described using a temporal change of the full charge capacity of the battery cell 204, but the deterioration may also be detected from a temporal change of characteristics other than the full charge capacity. The data analysis unit 104 of the present example detects a deviation amount D between a measurement value of the full charge capacity of the battery cell 204 and a reference value of the full charge capacity, as a deterioration amount of the battery cell 204. In Fig. 21, the measurement values of the full charge capacity are plotted by circles. Further, a curve obtained by approximating the respective plots is indicated by a solid line.

The reference value of the full charge capacity can be acquired from the reference characteristics of the full charge capacity. The reference characteristics of the full charge capacity are characteristics that show a change of the full charge capacity with respect to the number of charging/discharging times of the battery cell 204. The reference characteristics of the full charge capacity may be a designed value set by the manufacturer of the battery cell 204, or may be a statistical value acquired statistically. The reference characteristics of the battery cell 204 may be recorded in advance in the data analysis unit 104. Note that the data analysis unit 104 may correct the reference characteristics based on a temperature of the battery cell 204, a time during which the battery cell 204 is left in a full charge state or a minimally-charged state, or the like. The data analysis unit 104 may calculate a deviation rate at which the battery cell 204 deviates from the reference characteristics, from the relationship between the number of charging/discharging times and the deviation amount D.

The data analysis unit 104 may adjust the time intervals I described with reference to Fig. 20 based on the deviation amount D or the deviation rate. The data analysis unit 104 may shorten the time intervals I when the deviation amount D or the deviation rate becomes equal to or larger than a predetermined reference value. In the example of Fig. 21, the time interval I1 is adjusted to I2 at a timing the deviation amount D becomes equal to or larger than the reference value. Furthermore, when the deviation amount D becomes equal to or larger than the reference value, the data analysis unit 104 may notify the battery management device 206 to that effect.

Furthermore, the data analysis unit 104 may shorten the time intervals I when a deviation tendency between the characteristics of the battery cell 204 and the reference characteristics changes. For example, the data analysis unit 104 may judge that the deviation tendency has changed when a difference of the measurement value obtained this time from an approximate curve obtained by approximating the measurement values obtained up to last time, becomes equal to or larger than a predetermined value. In the example of Fig. 21, the time interval I2 is adjusted to I3 at a timing the deviation tendency changes. Furthermore, when the deviation amount D becomes equal to or larger than the reference value, the data analysis unit 104 may notify the battery management device 206 to that effect.

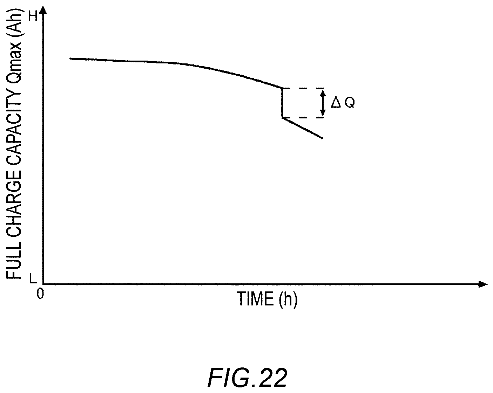

Fig. 22 shows another example of the analysis content by the data analysis unit 104. The data analysis unit 104 of the present example generates failure data indicating that a failure has occurred in the battery cell 204, based on the analysis result on the analysis data. As shown in Fig. 4, the data transmission unit 106 may transmit transmission data including the failure data to the battery management device 206.

The data analysis unit 104 of the present example generates the failure data based on a temporal change of the full charge capacity Qmax of the battery cell 204. When a decrease amount ΔQ of the full charge capacity calculated from the analysis data obtained this time from the full charge capacity calculated from the analysis data obtained last time exceeds a predetermined reference value, the data analysis unit 104 may judge that a failure has occurred in the battery cell 204. Accordingly, peeling of electrodes or a rapid characteristics change can be detected to be notified to the battery management device 206. Note that the characteristics to be used for judging a failure are not limited to the full charge capacity.

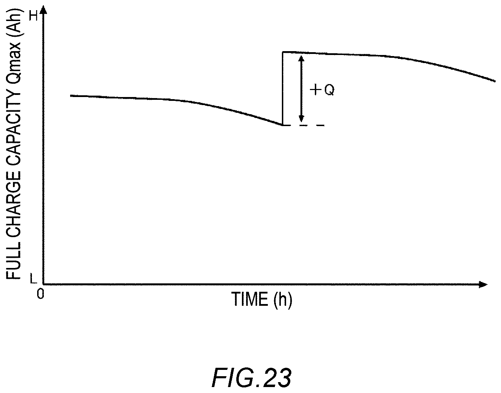

Fig. 23 shows another example of the analysis content by the data analysis unit 104. The data analysis unit 104 of the present example detects a replacement of the battery cell 204 based on the analysis result on the analysis data.

The data analysis unit 104 of the present example detects whether the battery cell 204 has been replaced based on a temporal change of the full charge capacity Qmax of the battery cell 204. When an increase amount +Q of the full charge capacity calculated from the analysis data obtained this time from the full charge capacity calculated from the analysis data obtained last time exceeds a predetermined reference value, the data analysis unit 104 may judge that the battery cell 204 has been replaced. The data analysis unit 104 may also judge that the battery cell 204 has been replaced based on a magnitude of the change of the characteristics other than the full charge capacity, such as the derivation characteristics.

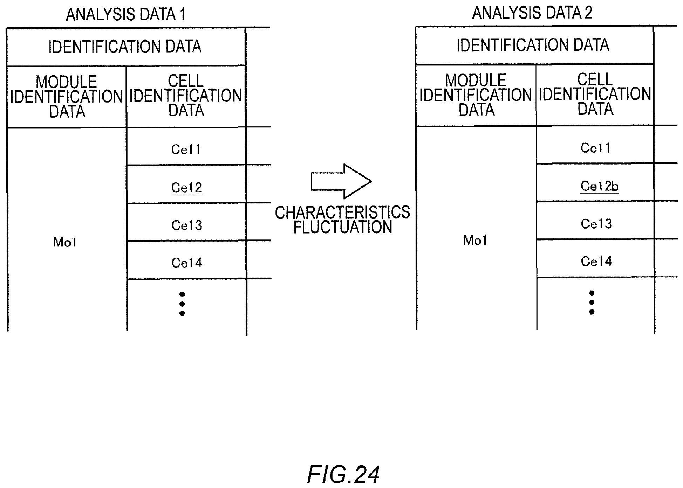

Fig. 24 shows an operation example of the data analysis unit 104. Fig. 24 shows time series analysis data 1 and 2 recorded by the analysis data recording unit 108. Timings of measuring the characteristics of the battery cell 204 differ between the analysis data 1 and 2.

The measurement unit 208 of the present example allocates cell identification data Ce to the measurement data of each of the battery cells 204 based on the position of each of the battery cells 204 in the battery module 202. For example, the measurement unit 208 allocates the cell identification data Ce for each voltmeter 215 shown in Fig. 15. Therefore, even when any of the battery cells 204 in the battery module 202 is replaced, the same cell identification data Ce is allocated to the battery cell 204 that is to be replaced and the battery cell 204 used for the replacement. In this case, if measurement data is managed for each cell identification data Ce in the analysis device 100, the measurement data of the battery cell 204 that is to be replaced and the measurement data of the battery cell 204 used for the replacement will be mixed up while being managed. In this case, it may become impossible to accurately analyze the characteristics of the battery cell 204.

The data analysis unit 104 allocates new cell identification data Ce to the battery cell 204 corresponding to the same cell identification data Ce, based on a history of measurement data corresponding to the same cell identification data Ce. As described with reference to Fig. 23, when a change of the full charge capacity calculated from the history of the measurement data is equal to or larger than a reference value, the data analysis unit 104 judges that the battery cell 204 has been replaced, and updates the cell identification data Ce of the battery cell 204. In the example of Fig. 24, cell identification data Ce12 is updated to cell identification data Ce12b. Accordingly, it becomes possible to prevent mix-up of the measurement data of the battery cell 204 before and after the replacement.

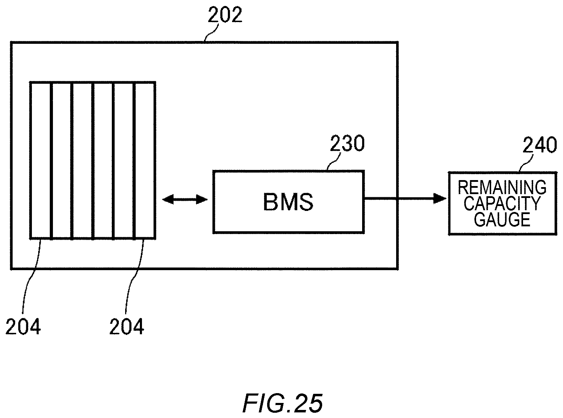

Fig. 25 shows another configuration example of the battery module 202. The battery module 202 of the present example includes a BMS 230 (Battery Management System) that manages the battery module 202. The BMS 230 may be the battery management device 206 shown in Fig. 2, or may be a circuit communicable with the battery management device 206. The BMS 230 notifies the remaining capacity gauge 240 of the estimated remaining capacity of the battery cell 204. The BMS 230 may notify the estimated remaining capacity of an individual battery cell 204, or may notify a sum of the estimated remaining capacities of the plurality of battery cells 204.

The remaining capacity gauge 240 may be mounted in the battery module 202, or may be arranged outside the battery module 202. The remaining capacity gauge 240 displays information related to the notified estimated remaining capacity.

The data analysis unit 104 may compare the estimated remaining capacity of the battery cell 204 notified by the BMS 230 and the analyzed remaining capacity of the battery cell 204 analyzed from the measurement data. The data transmission unit 106 may transmit transmission data including the compared result. Accordingly, it becomes possible to notify the battery management device 206 of whether the estimated remaining capacity displayed by the remaining capacity gauge 240 is correct. The compared result may be a difference between the estimated remaining capacity and the analyzed remaining capacity.

Various embodiments of the present invention may be described with reference to flowcharts and block diagrams, whose blocks may represent (1) steps of processes in which operations are executed or (2) sections of apparatuses responsible for executing operations. Certain steps and sections may be implemented by a dedicated circuit, a programmable circuit supplied together with computer-readable instructions stored on computer-readable media, or processors supplied together with computer-readable instructions stored on computer-readable media. The dedicated circuit may include a digital and/or analog hardware circuit, or may include an integrated circuit (IC) and/or a discrete circuit. The programmable circuit may include a reconfigurable hardware circuit including logical AND, logical OR, logical XOR, logical NAND, logical NOR, and other logical operations, a memory element such as a flip-flop, a register, a field programmable gate array (FPGA) and a programmable logic array (PLA), and the like.

A computer-readable medium may include any tangible device that can store instructions to be executed by a suitable device, and as a result, the computer-readable medium having instructions stored thereon includes an article of manufacture including instructions which can be executed to create means for performing operations specified in the flowcharts or block diagrams. Examples of the computer-readable medium may include an electronic storage medium, a magnetic storage medium, an optical storage medium, an electromagnetic storage medium, a semiconductor storage medium, and the like. More specific examples of the computer-readable medium may include a floppy (registered trademark) disk, a diskette, a hard disk, a random access memory (RAM), a read-only memory (ROM), an erasable programmable read-only memory (EPROM or flash memory), an electrically erasable programmable read-only memory (EEPROM), a static random access memory (SRAM), a compact disc read-only memory (CD-ROM), a digital versatile disk (DVD), a Blu-ray (registered trademark) disk, a memory stick, an integrated circuit card, and the like.

Computer-readable instructions may include assembler instructions, instruction-set-architecture (ISA) instructions, machine instructions, machine dependent instructions, microcode, firmware instructions, state-setting data, or either source code or object code written in any combination of one or more programming languages, including an object oriented programming language such as Smalltalk, JAVA (registered trademark), C++, etc., and conventional procedural programming languages, such as the "C" programming language or similar programming languages.

Computer-readable instructions may be provided to a processor of a general purpose computer, special purpose computer, or other programmable data processing apparatuses, or to a programmable circuit, locally or via a local area network (LAN), wide area network (WAN) such as the Internet, or the like, to execute the computer-readable instructions to create means for performing operations specified in the flowcharts or block diagrams. Examples of the processor include a computer processor, a processing unit, a microprocessor, a digital signal processor, a controller, a microcontroller, and the like.

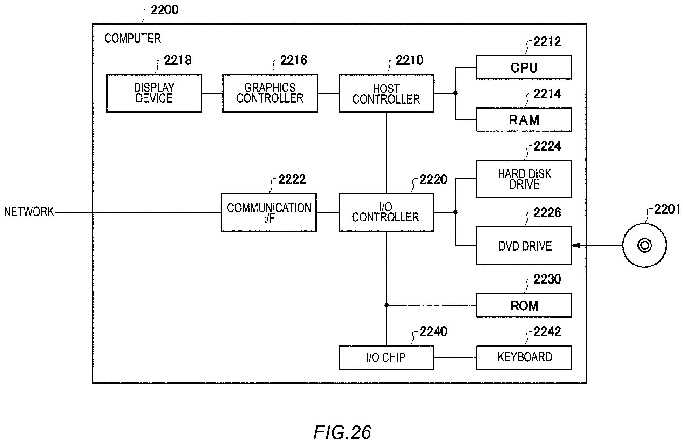

Fig. 26 illustrates an example of a computer 2200 in which a plurality of aspects of the present invention may be embodied in whole or in part. A program that is installed in the computer 2200 can cause the computer 2200 to function as or perform operations associated with apparatuses of the embodiments of the present invention or one or more sections thereof, and/or cause the computer 2200 to perform processes of the embodiments of the present invention or steps thereof. Such programs may be executed by a CPU 2212 to cause the computer 2200 to perform certain operations associated with some or all of the blocks in the flowcharts and block diagrams described in the present specification.

The computer 2200 according to the present embodiment includes the CPU 2212, a RAM 2214, a graphics controller 2216, and a display device 2218, which are mutually connected by a host controller 2210. The computer 2200 also includes input/output units such as a communication interface 2222, a hard disk drive 2224, a DVD-ROM drive 2226, and an IC card drive, which are connected to the host controller 2210 via an input/output controller 2220. The computer also includes legacy input/output units such as a ROM 2230 and a keyboard 2242, which are connected to the input/output controller 2220 via an input/output chip 2240.

The CPU 2212 operates according to programs stored in the ROM 2230 and the RAM 2214, thereby controlling each unit. The graphics controller 2216 obtains image data generated by the CPU 2212 on a frame buffer or the like provided in the RAM 2214 or in itself, and causes the image data to be displayed on the display device 2218.

The communication interface 2222 communicates with other electronic devices via a network. The hard disk drive 2224 stores programs and data used by the CPU 2212 in the computer 2200. The DVD-ROM drive 2226 reads the programs or the data from the DVD-ROM 2201, and provides the hard disk drive 2224 with the programs or the data via the RAM 2214. The IC card drive reads programs and data from the IC card, or writes programs and data to the IC card.

The ROM 2230 stores therein a boot program or the like executed by the computer 2200 at the time of activation, or a program depending on the hardware of the computer 2200. The input/output chip 2240 may also connect various input/output units to the input/output controller 2220 via a parallel port, a serial port, a keyboard port, a mouse port, or the like.

The program is provided by a computer-readable medium such as the DVD-ROM 2201 or the IC card. The program is read from a computer-readable medium, installed in the hard disk drive 2224, the RAM 2214, or the ROM 2230 which are also examples of the computer-readable medium, and executed by the CPU 2212. The information processing described in these programs is read by the computer 2200 and provides cooperation between the programs and various types of hardware resources. The apparatus or method may be configured by implementing operations or processing of information according to use of the computer 2200.

For example, in a case where communication is performed between the computer 2200 and an external device, the CPU 2212 may execute a communication program loaded in the RAM 2214 and instruct the communication interface 2222 to perform communication processing on the basis of processing described in the communication program. Under the control of the CPU 2212, the communication interface 2222 reads transmission data stored in a transmission buffer processing area provided in a recording medium such as the RAM 2214, the hard disk drive 2224, the DVD-ROM 2201, or the IC card, transmits the read transmission data to the network, or writes reception data received from the network in a reception buffer processing area or the like provided on the recording medium.

In addition, the CPU 2212 may cause the RAM 2214 to read all or a necessary part of a file or database stored in an external recording medium such as the hard disk drive 2224, the DVD-ROM drive 2226 (DVD-ROM 2201), the IC card, or the like, and may execute various types of processing on data on the RAM 2214. Next, the CPU 2212 writes back the processed data to the external recording medium.

Various types of information such as various types of programs, data, tables, and databases may be stored in a recording medium and subjected to information processing. The CPU 2212 may execute, on the data read from the RAM 2214, various types of processing including various types of operations, information processing, conditional judgement, conditional branching, unconditional branching, information retrieval/replacement, or the like described throughout the present disclosure and specified by instruction sequences of the programs, and writes the results back to the RAM 2214. In addition, the CPU 2212 may search for information in a file, a database, etc., in the recording medium. For example, when a plurality of entries, each having an attribute value of a first attribute associated with an attribute value of a second attribute, are stored in the recording medium, the CPU 2212 may search for an entry matching the condition whose attribute value of the first attribute is designated, from among the plurality of entries, and read the attribute value of the second attribute stored in the entry, thereby obtaining the attribute value of the second attribute associated with the first attribute satisfying the predetermined condition.

The programs or software modules described above may be stored in a computer-readable medium on or near the computer 2200. In addition, a recording medium such as a hard disk or a RAM provided in a server system connected to a dedicated communication network or the Internet can be used as a computer-readable medium, thereby providing a program to the computer 2200 via the network.

The operations, procedures, steps, and stages of each process performed by an apparatus, system, program, and method shown in the claims, embodiments, or diagrams can be performed in any order as long as the order is not indicated by "prior to," "before," or the like and as long as the output from a previous process is not used in a later process. Even if the process flow is described using phrases such as "first" or "next" in the claims, embodiments, or diagrams, it does not necessarily mean that the process must be performed in this order.

### EXPLANATION OF REFERENCES

- 10: analysis system
- 12: network
- 100: analysis device
- 102: data acquisition unit
- 104: data analysis unit
- 106: data transmission unit
- 108: analysis data recording unit
- 110: reference characteristics recording unit
- 200: analysis data transmission unit
- 202: battery module
- 204: battery cell
- 206: battery management device
- 208: measurement unit
- 211: positive terminal
- 212: negative terminal
- 213: discharging switch
- 214: discharge resistance
- 215: voltmeter
- 216: ammeter
- 218: negative electrode
- 220: graphite layer
- 222: lithium ion
- 230: BMS
- 240: remaining capacity gauge
- 2200: computer
- 2201: DVD-ROM
- 2210: host controller
- 2212: CPU
- 2214: RAM
- 2216: graphics controller
- 2218: display device
- 2220: input/output controller
- 2222: communication interface
- 2224: hard disk drive
- 2226: DVD-ROM drive
- 2230: ROM
- 2240: input/output chip
- 2242: keyboard

## Claims

1. An analysis device (100), comprising:
a data acquisition unit (102) configured to acquire, via a network (12), analysis data including measurement data (Me) obtained by measuring characteristics related to charging and discharging of one or more battery cells (204) included in one or more battery modules (202) and identification data (Mo, Ce) for identifying at least one of the battery modules (202) or the battery cells (204);
a data analysis unit (104) configured to analyze characteristics related to a charging capacity of at least one of the battery cells (204), based on the analysis data acquired by the data acquisition unit (102); and
a data transmission unit (106) configured to transmit transmission data corresponding to an analysis result obtained by the data analysis unit (104) via the network (12),
**characterized in that**
the battery cell (204) is identified by cell identification data (Ce),
the data analysis unit (104) is configured to allocate, based on a history of the measurement data (Me) corresponding to one piece of the cell identification data (Ce), a new piece of the cell identification data (Ce) to the battery cell (204) corresponding to the one piece of the cell identification data (Ce), and thus update the cell identification data (Ce) of the battery cell (204), and
the data analysis unit (104) is configured to judge that the battery cell (204) has been replaced, and update the cell identification data (Ce) of the battery cell (204) from the one piece of the cell identification data (Ce) to the new piece of the cell identification data (Ce), when a change of a full charge capacity calculated from the history of the measurement data (Me) is equal to or larger than a reference value.

2. The analysis device (100) according to claim 1, wherein
the data acquisition unit (102) is configured to acquire the identification data (Mo, Ce) in which module identification data (Mo) for identifying the battery modules (202) and cell identification data (Ce) for identifying the battery cells (204) are associated with each other, and
the data analysis unit (104) is configured to analyze the characteristics related to the charging capacity of the battery cell (204) for each of the battery modules (202).

3. The analysis device (100) according to claim 1 or 2, further comprising
an analysis data recording unit (108) configured to record the measurement data (Me) acquired by the data acquisition unit (102) over time, in association with the identification data (Mo, Ce).

4. The analysis device (100) according to any one of claims 1 to 3, wherein
the data analysis unit (104) is configured to generate control data for controlling the battery cell (204) based on the analysis result, and
the data transmission unit (106) is configured to transmit the transmission data including the control data.

5. The analysis device (100) according to claim 4, wherein
the data analysis unit (104) is configured to calculate a remaining capacity of each of the battery cells (204) in each of the battery modules (202) based on the measurement data (Me), and
the data analysis unit (104) is configured to generate the control data for discharging at least one of the battery cells (204) in which the remaining capacity is not smallest to reduce a difference between the remaining capacity of the at least one of the battery cells (204) and the remaining capacity of the battery cell (204) in which the remaining capacity is smallest.

6. The analysis device (100) according to any one of claims 1 to 5, wherein
the data analysis unit (104) is configured to generate replacement time data indicating a time to replace the battery cell (204) based on the analysis result, and
the data transmission unit (106) is configured to transmit the transmission data including the replacement time data.

7. The analysis device (100) according to any one of claims 1 to 6, wherein
the data analysis unit (104) is configured to generate failure data indicating a failure of the battery cell (204) based on the analysis result, and
the data transmission unit (106) is configured to transmit the transmission data including the failure data.

8. The analysis device (100) according to any one of claims 1 to 7, wherein
the data analysis unit (104) is configured to analyze the characteristics related to the charging capacity of the battery cell (204) based on derivation characteristics of capacitance-voltage characteristics obtained during charging or discharging of the battery cell (204).

9. The analysis device (100) according to claim 8, wherein
the data acquisition unit (102) is configured to acquire the analysis data including temperature data indicating a temperature of the battery cell (204) at a time of measuring the capacitance-voltage characteristics, and
the data analysis unit (104) is configured to correct the analysis by the derivation characteristics based on the temperature of the battery cell (204).

10. The analysis device (100) according to claim 8 or 9, further comprising
a reference characteristics recording unit (110) having recorded thereon reference characteristics of the derivation characteristics of each of the battery cells (204),
wherein
the reference characteristics include one or more reference feature points, and
the data analysis unit (104) is configured to analyze the battery cell (204) based on a measurement feature point in the derivation characteristics of the battery cell (204) and the one or more reference feature points in the reference characteristics.

11. The analysis device (100) according to claim 10, wherein
the reference characteristics recording unit (110) is configured to record at least one of the reference characteristics at the charging of the battery cell (204) or the reference characteristics at the discharging of the battery cell (204), and
the data analysis unit (104) is configured to select the reference characteristics to be compared with the derivation characteristics, based on which of data obtained during the charging or data obtained during the discharging the measurement data (Me) of the battery cell (204) is.

12. The analysis device (100) according to any one of claims 8 to 11, wherein
the data analysis unit (104) is configured to calculate a deterioration rate of the battery cell (204) based on a deterioration amount of the battery cell (204) calculated from the derivation characteristics.

13. The analysis device (100) according to claim 12, wherein
the data analysis unit (104) is configured to calculate a measurement interval for measuring data related to the charging and discharging of the battery cell (204), based on the deterioration rate of the battery cell (204), and
the data transmission unit (106) is configured to transmit the transmission data corresponding to the measurement interval.

14. The analysis device (100) according to any one of claims 8 to 13, wherein
the data analysis unit (104) is configured to calculate, based on a deviation amount of the charging capacities between two or more of the battery cells (204), the deviation amount being calculated from the derivation characteristics of the two or more of the battery cells (204), a deviation rate of the charging capacities between the two or more of the battery cells (204).

15. The analysis device (100) according to claim 14, wherein
the data analysis unit (104) is configured to calculate the measurement interval for measuring the data related to the charging and discharging of the two or more of the battery cells (204), based on the deviation rate of the two or more of the battery cells (204), and
the data transmission unit (106) is configured to transmit the transmission data corresponding to the measurement interval.

16. An analysis system, comprising:
the analysis device (100) according to any one of claims 1 to 15; and
an analysis data transmission unit (200) configured to transmit the analysis data to the analysis device (100) via the network (12).

17. An analysis method, comprising:
generating measurement data (Me) obtained by measuring characteristics related to charging and discharging of one or more battery cells (204) included in one or more battery modules (202);
transmitting, via a network (12), analysis data including the measurement data (Me) and identification data (Mo, Ce) for identifying at least one of the battery modules (202) or the battery cells (204);
acquiring the analysis data via the network (12);
analyzing characteristics related to a charging capacity of at least one of the battery cells (204), based on the analysis data acquired in the acquiring the analysis data; and
transmitting transmission data corresponding to an analysis result obtained in the analyzing the characteristics via the network,
**characterized in that**
the battery cell (204) is identified by cell identification data (Ce),
the analyzing the characteristics is to allocate, based on a history of the measurement data (Me) corresponding to one piece of the cell identification data (Ce), a new piece of the cell identification data (Ce) to the battery cell (204) corresponding to the one piece of the cell identification data (Ce), and thus update the cell identification data (Ce) of the battery cell (204), and
the analyzing the characteristics is to judge that the battery cell (204) has been replaced, and update the cell identification data (Ce) of the battery cell (204) from the one piece of the cell identification data (Ce) to the new piece of the cell identification data (Ce), when a change of a full charge capacity calculated from the history of the measurement data (Me) is equal to or larger than a reference value.

## Patentansprüche

1. Analysevorrichtung (100), die aufweist:
eine Datenbeschaffungseinheit (102), die so konfiguriert ist, dass sie über ein Netzwerk (12) Analysedaten beschafft, einschließlich Messdaten (Me), die durch Messen von Charakteristika in Bezug auf das Laden und Entladen einer oder mehrerer Batteriezellen (204), die in einem oder mehreren Batteriemodulen (202) enthalten sind, erhalten werden, und Identifikationsdaten (Mo, Ce) zum Identifizieren der Batteriemodule (202) und/oder der Batteriezellen (204);
eine Datenanalyseeinheit (104), die so konfiguriert ist, dass sie auf der Grundlage der von der Datenbeschaffungseinheit (102) beschafften Analysedaten Charakteristika analysiert, die sich auf eine Ladekapazität von mindestens einer der Batteriezellen (204) beziehen; und
eine Datenübertragungseinheit (106), die so konfiguriert ist, dass sie Übertragungsdaten, die einem von der Datenanalyseeinheit (104) erhaltenen Analyseergebnis entsprechen, über das Netzwerk (12) überträgt,
**dadurch gekennzeichnet, dass**
die Batteriezelle (204) durch Zellenidentifikationsdaten (Ce) identifiziert wird,
die Datenanalyseeinheit (104) so konfiguriert ist, dass sie auf der Grundlage einer Historie der Messdaten (Me), die einem Stück der Zellenidentifikationsdaten (Ce) entsprechen, ein neues Stück der Zellenidentifikationsdaten (Ce) der Batteriezelle (204) zuordnet, die dem einen Stück der Zellenidentifikationsdaten (Ce) entspricht, und somit die Zellenidentifikationsdaten (Ce) der Batteriezelle (204) aktualisiert, und
die Datenanalyseeinheit (104) so konfiguriert ist, dass sie feststellt, dass die Batteriezelle (204) ausgetauscht wurde, und die Zellenidentifikationsdaten (Ce) der Batteriezelle (204) von dem einen Stück der Zellenidentifikationsdaten (Ce) in das neue Stück der Zellenidentifikationsdaten (Ce) aktualisiert, wenn eine aus der Historie der Messdaten (Me) berechnete Änderung einer vollen Ladekapazität gleich oder größer als ein Referenzwert ist.

2. Analysevorrichtung (100) nach Anspruch 1, wobei
die Datenbeschaffungseinheit (102) so konfiguriert ist, dass sie die Identifikationsdaten (Mo, Ce) beschafft, in denen Modul-Identifikationsdaten (Mo) zur Identifizierung der Batteriemodule (202) und Zellenidentifikationsdaten (Ce) zur Identifizierung der Batteriezellen (204) einander zugeordnet sind, und
die Datenanalyseeinheit (104) so konfiguriert ist, dass sie die Charakteristika in Bezug auf die Ladekapazität der Batteriezelle (204) für jedes der Batteriemodule (202) analysiert.

3. Analysevorrichtung (100) nach Anspruch 1 oder 2, die ferner aufweist:
eine Analysedatenaufzeichnungseinheit (108), die so konfiguriert ist, dass sie die von der Datenbeschaffungseinheit (102) beschafften Messdaten (Me) im Laufe der Zeit in Verbindung mit den Identifikationsdaten (Mo, Ce) aufzeichnet.

4. Analysevorrichtung (100) nach einem der Ansprüche 1 bis 3, wobei
die Datenanalyseeinheit (104) so konfiguriert ist, dass sie auf der Grundlage des Analyseergebnisses Steuerdaten zur Steuerung der Batteriezelle (204) erzeugt, und
die Datenübertragungseinheit (106) so konfiguriert ist, dass sie die Übertragungsdaten einschließlich der Steuerdaten überträgt.

5. Analysevorrichtung (100) nach Anspruch 4, wobei
die Datenanalyseeinheit (104) so konfiguriert ist, dass sie eine Restkapazität jeder der Batteriezellen (204) in jedem der Batteriemodule (202) auf der Grundlage der Messdaten (Me) berechnet, und
die Datenanalyseeinheit (104) so konfiguriert ist, dass sie die Steuerdaten zum Entladen von mindestens einer der Batteriezellen (204) erzeugt, in der die Restkapazität nicht am geringsten ist, um eine Differenz zwischen der Restkapazität der mindestens einen der Batteriezellen (204) und der Restkapazität der Batteriezelle (204), in der die Restkapazität am geringsten ist, zu verringern.

6. Analysevorrichtung (100) nach einem der Ansprüche 1 bis 5, wobei
die Datenanalyseeinheit (104) so konfiguriert ist, dass sie Austauschzeitdaten erzeugt, die eine Zeit für den Austausch der Batteriezelle (204) auf der Grundlage des Analyseergebnisses angeben, und
die Datenübertragungseinheit (106) so konfiguriert ist, dass sie die Übertragungsdaten einschließlich der Austauschzeitdaten überträgt.

7. Analysevorrichtung (100) nach einem der Ansprüche 1 bis 6, wobei
die Datenanalyseeinheit (104) so konfiguriert ist, dass sie auf der Grundlage des Analyseergebnisses Fehlerdaten erzeugt, die einen Fehler der Batteriezelle (204) anzeigen, und
die Datenübertragungseinheit (106) so konfiguriert ist, dass sie die Übertragungsdaten einschließlich der Fehlerdaten überträgt.

8. Analysevorrichtung (100) nach einem der Ansprüche 1 bis 7, wobei
die Datenanalyseeinheit (104) so konfiguriert ist, dass sie die Charakteristika in Bezug auf die Ladekapazität der Batteriezelle (204) auf der Grundlage von Ableitungscharakteristika von Kapazitäts-Spannungs-Kennlinien analysiert, die während des Ladens oder Entladens der Batteriezelle (204) erhalten werden.

9. Analysevorrichtung (100) nach Anspruch 8, wobei
die Datenbeschaffungseinheit (102) so konfiguriert ist, dass sie die Analysedaten einschließlich Temperaturdaten beschafft, die eine Temperatur der Batteriezelle (204) zum Zeitpunkt der Messung der Kapazitäts-Spannungs-Kennlinie anzeigen, und
die Datenanalyseeinheit (104) so konfiguriert ist, dass sie die Analyse durch die Ableitungscharakteristika basierend auf der Temperatur der Batteriezelle (204) korrigiert.

10. Analysevorrichtung (100) nach Anspruch 8 oder 9, die ferner aufweist:
eine Referenzcharakteristikaufzeichnungseinheit (110) mit darin aufgezeichneten Referenzcharakteristika der Ableitungscharakteristika jeder der Batteriezellen (204),
wobei
die Referenzcharakteristika einen oder mehrere Referenzmerkmalspunkte enthalten, und
die Datenanalyseeinheit (104) so konfiguriert ist, dass sie die Batteriezelle (204) basierend auf einem Messmerkmalspunkt in den Ableitungscharakteristika der Batteriezelle (204) und dem einen oder den mehreren Referenzmerkmalspunkten in den Referenzcharakteristika analysiert.

11. Analysevorrichtung (100) nach Anspruch 10, wobei
die Referenzcharakteristikaufzeichnungseinheit (110) so konfiguriert ist, dass sie die Referenzcharakteristika beim Laden der Batteriezelle (204) und/oder die Referenzcharakteristika beim Entladen der Batteriezelle (204) aufzeichnet, und
die Datenanalyseeinheit (104) so konfiguriert ist, dass sie basierend darauf, welche der während des Ladens erhaltenen Daten oder der während des Entladens erhaltenen Daten die Messdaten (Me) der Batteriezelle (204) sind, die mit den Ableitungscharakteristika zu vergleichenden Referenzcharakteristika auswählt.

12. Analysevorrichtung (100) nach einem der Ansprüche 8 bis 11, wobei
die Datenanalyseeinheit (104) so konfiguriert ist, dass sie eine Verschlechterungsrate der Batteriezelle (204) auf der Grundlage eines aus den Ableitungscharakteristika berechneten Verschlechterungsbetrags der Batteriezelle (204) berechnet.

13. Analysevorrichtung (100) nach Anspruch 12, wobei
die Datenanalyseeinheit (104) so konfiguriert ist, dass sie ein Messintervall zum Messen von Daten, die sich auf das Laden und Entladen der Batteriezelle (204) beziehen, basierend auf der Verschlechterungsrate der Batteriezelle (204) berechnet, und
die Datenübertragungseinheit (106) so konfiguriert ist, dass sie die dem Messintervall entsprechenden Übertragungsdaten überträgt.

14. Analysevorrichtung (100) nach einem der Ansprüche 8 bis 13, wobei
die Datenanalyseeinheit (104) so konfiguriert ist, dass sie auf der Grundlage eines Abweichungsbetrags der Ladekapazitäten zwischen zwei oder mehr der Batteriezellen (204) eine Abweichungsrate der Ladekapazitäten zwischen den zwei oder mehr der Batteriezellen (204) berechnet, wobei der Abweichungsbetrag aus den Ableitungscharakteristika von den zwei oder mehr der Batteriezellen (204) berechnet wird.

15. Analysevorrichtung (100) nach Anspruch 14, wobei
die Datenanalyseeinheit (104) so konfiguriert ist, dass sie das Messintervall zum Messen der Daten, die sich auf das Laden und Entladen der zwei oder mehr der Batteriezellen (204) beziehen, basierend auf der Abweichungsrate von den zwei oder mehr der Batteriezellen (204) berechnet, und
die Datenübertragungseinheit (106) so konfiguriert ist, dass sie die dem Messintervall entsprechenden Übertragungsdaten überträgt.

16. Analysesystem, das aufweist:
die Analysevorrichtung (100) nach einem der Ansprüche 1 bis 15; und
eine Analysedatenübertragungseinheit (200), die so konfiguriert ist, dass sie die Analysedaten über das Netzwerk (12) an die Analysevorrichtung (100) überträgt.

17. Analyseverfahren, das aufweist:
Erzeugen von Messdaten (Me), die durch Messen von Charakteristika in Bezug auf das Laden und Entladen einer oder mehrerer Batteriezellen (204), die in einem oder mehreren Batteriemodulen (202) enthalten sind, erhalten werden;
Übertragen von Analysedaten einschließlich der Messdaten (Me) und Identifikationsdaten (Mo, Ce) zur Identifizierung der Batteriemodule (202) und/oder der Batteriezellen (204) über ein Netzwerk (12);
Beschaffen der Analysedaten über das Netzwerk (12);
Analysieren von Charakteristika, die sich auf eine Ladekapazität von mindestens einer der Batteriezellen (204) beziehen, basierend auf den Analysedaten, die beim Beschaffen der Analysedaten beschafft werden; und
Übertragen von Übertragungsdaten, die einem bei der Analyse der Charakteristika erzielten Analyseergebnis entsprechen, über das Netzwerk,
**dadurch gekennzeichnet, dass**
die Batteriezelle (204) durch Zellenidentifikationsdaten (Ce) identifiziert wird,
das Analysieren der Charakteristika dazu dient, basierend auf einer Historie der Messdaten (Me), die einem Stück der Zellenidentifikationsdaten (Ce) entsprechen, der Batteriezelle (204), die dem einen Stück der Zellenidentifikationsdaten (Ce) entspricht, ein neues Stück der Zellenidentifikationsdaten (Ce) zuzuordnen und somit die Zellenidentifikationsdaten (Ce) der Batteriezelle (204) zu aktualisieren, und
das Analysieren der Charakteristika dazu dient, festzustellen, dass die Batteriezelle (204) ausgetauscht wurde, und die Zellenidentifikationsdaten (Ce) der Batteriezelle (204) von dem einen Stück der Zellenidentifikationsdaten (Ce) in das neue Stück der Zellenidentifikationsdaten (Ce) zu aktualisieren, wenn eine aus der Historie der Messdaten (Me) berechnete Änderung einer vollen Ladekapazität gleich oder größer als ein Referenzwert ist.

## Revendications

1. Dispositif d'analyse (100), comprenant :
une unité d'acquisition de données (102) configurée pour acquérir, via un réseau (12), des données d'analyse incluant des données de mesure (Me) obtenues en mesurant des propriétés relatives à la charge et à la décharge d'une ou de plusieurs cellules de batterie (204) incluses dans un ou plusieurs modules de batterie (202) et des données d'identification (Mo, Ce) pour identifier au moins l'un des modules de batterie (202) ou des cellules de batterie (204) ;
une unité d'analyse de données (104) configurée pour analyser les propriétés relatives à la capacité de charge d'au moins une des cellules de batterie (204), sur la base des données d'analyse acquises par l'unité d'acquisition de données (102) ; et
une unité de transmission de données (106) configurée pour transmettre des données de transmission correspondant à un résultat d'analyse obtenu par l'unité d'analyse de données (104) via le réseau (12),
**caractérisé en ce que**
la cellule de batterie (204) est identifiée par des données d'identification de cellule (Ce),
l'unité d'analyse de données (104) est configurée pour attribuer, sur la base d'un historique des données de mesure (Me) correspondant à une donnée d'identification de cellule (Ce), une nouvelle donnée d'identification de cellule (Ce) à la cellule de batterie (204) correspondant à la donnée d'identification de cellule (Ce), et ainsi mettre à jour les données d'identification de cellule (Ce) de la cellule de batterie (204), et
l'unité d'analyse de données (104) est configurée pour estimer que la cellule de batterie (204) a été remplacée et mettre à jour les données d'identification de cellule (Ce) de la cellule de batterie (204) de la donnée d'identification de cellule (Ce) à la nouvelle donnée d'identification de cellule (Ce), lorsqu'un changement d'une capacité de charge pleine calculée à partir de l'historique des données de mesure (Me) est égal ou supérieur à une valeur de référence.

2. Dispositif d'analyse (100) selon la revendication 1, dans lequel :
l'unité d'acquisition de données (102) est configurée pour acquérir les données d'identification (Mo, Ce) dans lesquelles les données d'identification de module (Mo) pour identifier les modules de batterie (202) et les données d'identification de cellule (Ce) pour identifier les cellules de batterie (204) sont associées les unes aux autres, et
l'unité d'analyse de données (104) est configurée pour analyser les propriétés relatives à la capacité de charge de la cellule de batterie (204) pour chacun des modules de batterie (202).

3. Dispositif d'analyse (100) selon la revendication 1 ou 2, comprenant en outre
une unité d'enregistrement de données d'analyse (108) configurée pour enregistrer les données de mesure (Me) acquises par l'unité d'acquisition de données (102) au fil du temps, en association avec les données d'identification (Mo, Ce).

4. Dispositif d'analyse (100) selon l'une quelconque des revendications 1 à 3, dans lequel
l'unité d'analyse de données (104) est configurée pour générer des données de commande pour commander la cellule de batterie (204) sur la base du résultat d'analyse, et
l'unité de transmission de données (106) est configurée pour transmettre les données de transmission incluant les données de commande.

5. Dispositif d'analyse (100) selon la revendication 4, dans lequel
l'unité d'analyse de données (104) est configurée pour calculer une capacité restante de chacun des cellules de batterie (204) dans chacun des modules de batterie (202) sur la base des données de mesure (Me), et
l'unité d'analyse de données (104) est configurée pour générer les données de commande pour décharger au moins une des cellules de batterie (204) dans laquelle la capacité restante n'est pas la plus faible, afin de réduire une différence entre la capacité restante de la au moins une des cellules de batterie (204) et la capacité restante de la cellule de batterie (204) dans laquelle la capacité restante est la plus faible.

6. Dispositif d'analyse (100) selon l'une quelconque des revendications 1 à 5, dans lequel
l'unité d'analyse de données (104) est configurée pour générer des données de délai de remplacement indiquant un délai pour remplacer la cellule de batterie (204) sur la base du résultat d'analyse, et
l'unité de transmission de données (106) est configurée pour transmettre les données de transmission incluant les données de délai de remplacement.

7. Dispositif d'analyse (100) selon l'une quelconque des revendications 1 à 6, dans lequel
l'unité d'analyse de données (104) est configurée pour générer des données de défaillance indiquant une défaillance de la cellule de batterie (204) sur la base du résultat d'analyse, et
l'unité de transmission de données (106) est configurée pour transmettre les données de transmission incluant les données de défaillance.

8. Dispositif d'analyse (100) selon l'une quelconque des revendications 1 à 7, dans lequel
l'unité d'analyse de données (104) est configurée pour analyser les propriétés relatives à la capacité de charge de la cellule de batterie (204) sur la base de propriétés de dérivation de propriétés de capacité-tension obtenues pendant la charge ou la décharge de la cellule de batterie (204).

9. Dispositif d'analyse (100) selon la revendication 8, dans lequel
l'unité d'acquisition de données (102) est configurée pour acquérir les données d'analyse incluant des données de température indiquant une température de la cellule de batterie (204) à un moment de la mesure des propriétés de capacité-tension, et
l'unité d'analyse de données (104) est configurée pour corriger l'analyse par les propriétés de dérivation sur la base de la température de la cellule de batterie (204).

10. Dispositif d'analyse (100) selon la revendication 8 ou 9, comprenant en outre
une unité d'enregistrement de propriétés de référence (110) présentant enregistrées sur celle-ci des propriétés de référence des propriétés de dérivation de chacun des cellules de batterie (204),
dans lequel
les propriétés de référence incluent un ou plusieurs points caractéristiques de référence, et
l'unité d'analyse de données (104) est configurée pour analyser la cellule de batterie (204) sur la base d'un point caractéristique de mesure dans les propriétés de dérivation de la cellule de batterie (204) et des un ou plusieurs points caractéristiques de référence dans les propriétés de référence.

11. Dispositif d'analyse (100) selon la revendication 10, dans lequel
l'unité d'enregistrement de propriétés de référence (110) est configurée pour enregistrer au moins une parmi les propriétés de référence lors de la charge de la cellule de batterie (204) ou les propriétés de référence lors de la décharge de la cellule de batterie (204), et
l'unité d'analyse de données (104) est configurée pour sélectionner les propriétés de référence à comparer aux propriétés de dérivation, sur la base des données obtenues pendant la charge ou des données obtenues pendant la décharge qui constituent les données de mesure (Me) de la cellule de batterie (204).

12. Dispositif d'analyse (100) selon l'une quelconque des revendications 8 à 11, dans lequel
l'unité d'analyse de données (104) est configurée pour calculer un taux de détérioration de la cellule de batterie (204) sur la base d'une quantité de détérioration de la cellule de batterie (204) calculée à partir des propriétés de dérivation.

13. Dispositif d'analyse (100) selon la revendication 12, dans lequel
l'unité d'analyse de données (104) est configurée pour calculer un intervalle de mesure pour mesurer les données relatives à la charge et à la décharge de la cellule de batterie (204), sur la base du taux de détérioration de la cellule de batterie (204), et
l'unité de transmission de données (106) est configurée pour transmettre les données de transmission correspondant à l'intervalle de mesure.

14. Dispositif d'analyse (100) selon l'une quelconque des revendications 8 à 13, dans lequel
l'unité d'analyse de données (104) est configurée pour calculer, sur la base d'une quantité d'écart des capacités de charge entre deux des cellules de batterie (204) ou plus, la quantité d'écart étant calculée à partir des propriétés de dérivation des deux cellules de batterie (204) ou plus, un taux d'écart des capacités de charge entre les deux cellules de batterie (204) ou plus.

15. Dispositif d'analyse (100) selon la revendication 14, dans lequel
l'unité d'analyse de données (104) est configurée pour calculer l'intervalle de mesure pour mesurer les données relatives à la charge et à la décharge des deux cellules de batterie (204) ou plus, sur la base du taux d'écart des deux cellules de batterie (204) ou plus, et
l'unité de transmission de données (106) est configurée pour transmettre les données de transmission correspondant à l'intervalle de mesure.

16. Système d'analyse, comprenant :
le dispositif d'analyse (100) selon l'une quelconque des revendications 1 à 15 ; et
une unité de transmission de données d'analyse (200) configurée pour transmettre les données d'analyse au dispositif d'analyse (100) via le réseau (12).

17. Procédé d'analyse, comprenant :
la génération de données de mesure (Me) obtenues en mesurant des propriétés relatives à la charge et à la décharge d'une ou de plusieurs cellules de batterie (204) incluses dans un ou plusieurs modules de batterie (202) ;
la transmission, via un réseau (12), de données d'analyse incluant les données de mesure (Me) et données d'identification (Mo, Ce) pour identifier au moins l'un des modules de batterie (202) ou des cellules de batterie (204) ;
l'acquisition des données d'analyse via le réseau (12) ;
l'analyse des propriétés relatives à la capacité de charge d'au moins une des cellules de batterie (204), sur la base des données d'analyse acquises lors de l'acquisition des données d'analyse ; et
la transmission des données de transmission correspondant à un résultat d'analyse obtenu lors de l'analyse des propriétés via le réseau,
**caractérisé en ce que**
la cellule de batterie (204) est identifiée par des données d'identification de cellule (Ce),
l'analyse des propriétés consiste à attribuer, sur la base d'un historique des données de mesure (Me) correspondant à une donnée d'identification de cellule (Ce), une nouvelle donnée d'identification de cellule (Ce) à la cellule de batterie (204) correspondant à la donnée d'identification de cellule (Ce), et ainsi mettre à jour les données d'identification de cellule (Ce) de la cellule de batterie (204), et
l'analyse des propriétés consiste à estimer que la cellule de batterie (204) a été remplacée et à mettre à jour les données d'identification de cellule (Ce) de la cellule de batterie (204) de la donnée d'identification de cellule (Ce) à la nouvelle donnée d'identification de cellule (Ce), lorsqu'un changement d'une capacité de charge pleine calculée à partir de l'historique des données de mesure (Me) est égal ou supérieur à une valeur de référence.
